# EUROPEAN PATENT APPLICATION

(11) **EP 4 568 096 A1**
(43) Date of publication of application: **11.06.2025**
(21) Application number: 23849681.4
(22) Date of filing: 24.02.2023
(51) Int. Cl.: H02M 7/48, H02M 7/493, H03F 3/20, H03F 3/68

(54) **HIGH-FREQUENCY POWER SUPPLY DEVICE**

(30) Priority: 04.08.2022 JP 2022124428
(71) Applicant: Kyosan Electric Mfg. Co., Ltd., Tsurumi-ku, Yokohama-shi Kanagawa 230-0031 (JP)
(72) Inventor: TEI Unbou, Yokohama-shi, Kanagawa 230-0031 (JP); SUZUKI Ryota, Yokohama-shi, Kanagawa 230-0031 (JP)
(74) Representative: Hoffmann Eitle
(86) International application number: PCT/JP2023/006778
(87) International publication number: WO 2024/029113

(57) **Abstract**

The high-frequency power supply device according to the present invention has a control unit that controls the output level of a synthetic output obtained by synthesizing the powers of the amplifier outputs of multiple power amplifiers. The control unit performs control by: (a) setting an amplifier output reference value p_{ref} for determining the output level of each amplifier output; (b) comparing the amplifier output reference value p_{ref} with each amplifier output feedback value p_{fb}; (c) setting, with respect to each power amplifier, a manipulated variable MV for controlling the output level of the amplifier output of each power amplifier; and (d) controlling the output level of the amplifier output of each power amplifier on the basis of each set manipulated variable MV. In the high-frequency power supply device that synthesizes multiple amplifier output powers amplified by the multiple power amplifiers, the reduction of power supply efficiency is suppressed, which is caused by the power differences of the amplifier outputs of the respective power amplifiers.

## Description

### [TECHNICAL FIELD]

The present invention relates to a high-frequency power supply device that includes a power amplification unit consisting of multiple power amplifiers and a power synthesis unit, and particularly relates to a high-frequency power supply device that distributes a high-frequency signal over the multiple power amplifiers, and synthesizes power of amplifier outputs by each power amplifier in the power synthesis unit so as to output a synthetic output.

### [BACKGROUND ART]

There are known high-frequency power supply devices, in which a power amplification unit is structured with multiple power amplifiers arranged in parallel, and amplifier outputs obtained by the multiple amplifiers are synthesized in a power synthesis unit so as to output a synthetic output. Such a known high-frequency power supply device includes a linear amplifier type high-frequency power supply device that employs a class-AB amplifier as each power amplifier (see Patent Literature 1) and a switching amplifier type high-frequency power supply device that employs a class-D amplifier as each power amplifier (see Patent Literature 2).

In a linear amplifier type high-frequency power supply device that includes multiple power amplifiers arranged in parallel, output power amplified in each power amplifier fluctuates due to variation in characteristics of semiconductor devices, such as MOSFET and bipolar transistor, used in the power amplifiers and variation in circuit components used in peripheral amplifier circuits of the power amplifier. For example, if output power in a certain power amplifier is 1000 W (60 dBm) and the gain of this power amplifier fluctuates by up to ±1.5 dB, the output power when the gain fluctuates by -1.5 dB is 708 W (58.5 dBm) and the output power when the gain fluctuates by +1.5 dB is 1412 W (61.5 dBm). Consequently, power fluctuations occur with a maximum power difference of approximately 300 W above and below the reference power of 1000 W.

In regard to the fluctuation in the output power of the power amplifier, Patent Literature 1 discloses that an optimal output level is set by comparing the output levels of the output power in two power amplifiers, and a control voltage in a variable attenuator included in the power amplifier is adjusted to control the amount of attenuation of the variable attenuator so as to minimize a loss in a power synthesis unit.

Patent Literature 2 discloses that a power amplification unit consists of two parallel-connected power amplifiers, in which the phases of the two power amplifiers are varied with respect to a rapidly changing load, thereby varying a harmonic output.

### [PRIOR ART DOCUMENT]

### [PATENT LITERATURE]

[Patent Literature 1] Japanese Patent Laid-Open Publication No. 2001-237651
[Patent Literature 2] Japanese Patent Laid-Open Publication No. 2021-106462

### [SUMMARY OF THE INVENTION]

### [PROBLEMS TO BE SOLVED BY THE INVENTION]

A synthetic output of a high-frequency power supply device can be obtained by conducting power synthesis on amplifier outputs of multiple power amplifiers. The efficiency of a power supply in each power amplifier, however, changes due to output power depending on the characteristics of semiconductor devices that form each power amplifier.

When difference in output power occurs due to variations in the semiconductor devices and circuit components included in each power amplifier, output power/power supply efficiency characteristics cause the change in the power supply efficiency of each power amplifier, resulting in a difference in the power supply efficiencies in the multiple power amplifiers. As above, when the power supply efficiencies in the multiple power amplifiers become unequal, the power amplifiers cannot be driven with optimal power supply efficiencies when the amplifier outputs are synthesized. It causes a decrease in overall power supply efficiency in the high-frequency power supply device.

As to the above-described conventional arts, Patent Literature 1 describes that the output levels in the two power amplifiers are compared with respect to the fluctuation of the output power in the high-frequency power supply device, and the amount of attenuation of each power amplifier is adjusted to minimize the loss in the power synthesis device. However, Patent Literature 1 does not disclose any problems and means for solving the problems in connection with the power supply efficiency of each power amplifier of the high-frequency power supply device.

Furthermore, Patent Literature 2 describes that the phases of the two power amplifiers are changed with respect to the rapidly changing load so as to reduce electrical stress caused in the circuit components of the high-frequency power supply device and a load device during the sudden change in the load, without upsizing the power supply device. However, Patent Literature 2 does not disclose any problems and means for solving the problems in connection with the power supply efficiency of each power amplifier of the high-frequency power supply device.

An object of the present invention is to solve the above-described existing problems, and to prevent the decrease in power supply efficiency in a high-frequency power supply device caused by a difference in power of the amplifier outputs of power amplifiers in the high-frequency power supply device that performs power synthesis on the power of multiple amplifier outputs amplified by multiple power amplifiers.

### [MEANS FOR SOLVING THE PROBLEM]

### (A) High-Frequency Power Supply Device

### A1: Configuration

A high-frequency power supply device of the present invention includes:
a power amplification unit that is formed by multiple power amplifiers arranged to connect in parallel;
a distribution unit that distributes a high-frequency signal over the power amplifiers;
a power synthesis unit that performs power synthesis on multiple amplifier outputs amplified in the multiple power amplifiers to thereby deliver the obtained synthetic output; and
a detector that detects a feedback value, and a control unit that controls output levels.

The present invention has, as the detectors, an amplifier output detection unit that detects an amplifier output feedback value p_{fb} of each power amplifier and a synthetic output detection unit that detects a synthetic output feedback value P_{FB}. The synthetic output detection unit is connected between the power synthesis unit and an output end, and is configured to separate forward power traveling from the output end toward a load and reflected power travelling from the output end toward the power synthesis unit, so as to detect the synthetic output feedback value P_{FB} from the forward power. The synthetic output detection unit can employ a directional coupler, by way of example.

The control unit of the present invention is configured to:
(a) define an amplifier output reference value p_{ref} (amplifier output command value p_{com} or amplifier output conversion value p_{FB}) that defines an output level of each amplifier output based on the synthetic output command value P_{com} or the synthetic output feedback value P_{FB};
(b) compare the amplifier output feedback value p_{fb} detected by the amplifier output detection unit with the amplifier output reference value p_{ref} (amplifier output command value p_{com}, amplifier output conversion value p_{FB});
(c) set a manipulated variable MV for each power amplifier that controls the output level of each amplifier output of the power amplifier; and
(d) control the output level of each amplifier output of each power amplifier based on the set manipulated variable MV.

The reference sign "P" means a synthetic output, and the reference sign "p" means an amplifier output. As to the letter strings appended after the signs P and p, the string "com" means a command value, the string "ref" means a reference value, the string "FB" means feedback of the synthetic output, and the string "fb" means feedback of the amplifier output.

The synthetic output command value P_{com} is a command value for defining a target value of the synthetic output of the power synthesis unit.

The amplifier output feedback value p_{fb} is a power value of the amplifier output of each power amplifier and is detected by the amplifier output detection unit.

The synthetic output feedback value P_{FB} is a power value of the synthetic output of the power synthesis unit and is detected by the synthetic output detection unit.

The amplifier output reference value p_{ref} is a reference value for defining the output level of the amplifier output, and the amplifier output command value p_{com} or the amplifier output conversion value p_{FB} can be used as this reference value.

The amplifier output command value p_{com} is an output command value for one power amplifier defined in each power amplifier, and is calculated by dividing the synthetic output command value P_{com} proportionately according to the number N which is the number of the power amplifiers and the output power/power supply efficiency characteristic of the power amplifiers.

The amplifier output conversion value p_{FB} is an amplifier output defined in each power amplifier, and is calculated by divining the synthetic output feedback value P_{FB} proportionately according to the number N which is the number of the power amplifiers and the output power/power supply efficiency characteristic of the power amplifiers.

For setting the manipulated variable MV for controlling the output level of the amplifier output of each power amplifier, the present invention (a) defines the amplifier output reference value p_{ref} (amplifier output command value p_{com} or amplifier output conversion value p_{FB}) for defining the output level of each amplifier output based on the synthetic output command value P_{com} for defining the output level of the synthetic output for the amplifier output of each power amplifier or the synthetic output feedback value P_{FB}, and (b) compares the amplifier output reference value p_{ref} (amplifier output command value p_{com} or amplifier output conversion value p_{FB}) as a reference for controlling the output level of each amplifier output with the amplifier output feedback value p_{fb}, so as to obtain a reference value, which is stable and independent from the feedback value of each amplifier output, for setting the manipulated variable MV for controlling each power amplifier, thereby stabilizing the control on the output levels.

In the control conducted by a conventional device, the feedback values of the amplifier outputs are compared with one another to thereby set the manipulated variable MV based on a relative comparison between these feedback values. Consequently, it is difficult to determine which feedback value is normal, causing instability in the reference for setting the manipulated variable MV. By contrast, the present invention defines the amplifier output reference value p_{ref} (amplifier output command value p_{com} or amplifier output conversion value p_{FB}) for each power amplifier based on the synthetic output command value P_{com} or the synthetic output feedback value P_{FB}, and uses these amplifier output reference values p_{ref} (amplifier output command value p_{com} or amplifier output conversion value p_{FB}) as a reference value to compare with each amplifier output feedback value pfb, so that the manipulated variable MV can be set without depending on the feedback value of each amplifier output.

In the conventional high-frequency power supply device, if one power amplifier fails and is unable to output power, the entire equipment may be shut down. By contrast, in the high-frequency power supply device of the present invention, even if one power amplifier fails and is unable to output power, the output balance of the other power amplifiers is automatically optimized, thereby maintaining its operation.

### A2: Setting of manipulated variable MV

For setting the manipulated variable MV, the amplifier output reference value p_{ref} (amplifier output command value p_{com} or amplifier output conversion value p_{FB}) of each power amplifier, which is used as a reference value for comparing with the amplifier output feedback value p_{fb}, can be obtained by a setting mode (A2-a) that is on the basis of the synthetic output command value P_{com} or a setting mode (A2-b) that is on the basis of the synthetic output feedback value P_{FB}.

### A2-a: Setting mode for manipulated variable MV based on synthetic output command value P_{com}

This setting mode sets the amplifier output command value p_{com} as the manipulated variable MV for each power amplifier based on the synthetic output command value P_{com}.

The control unit defines the amplifier output command value p_{com} of each power amplifier based on the synthetic output command value P_{com} for defining the output level of the synthetic output, the number N of the power amplifiers, and the output power/power supply efficiency characteristic of each power amplifier. In addition to that, the control unit sets the manipulated variable MV for controlling the amplifier output feedback value p_{fb} detected by each amplifier output detection unit to be the amplifier output command value p_{com}, so as to control a gain of the power amplifier based on the set manipulated variable MV. In here, the number N of the power amplifiers is an integer equal to or greater than 2 and corresponds to the number of the power amplifiers.

For setting the manipulated variable MV, there are a setting mode (a1) that makes the outputs of the power amplifiers to have an equal output level and a setting mode (a2) that makes the outputs of the power amplifiers to have individual output levels.

### (a1) Setting mode for equal output level

In this setting mode, the power amplifiers have the same output power/power supply efficiency characteristic, and each output power is set such that the power supply efficiency of each power amplifier is the same.

The control unit divides the synthetic output command value P_{com} by the number N of the power amplifiers to calculate a value (synthetic output command value P_{com}/number N: (P_{com}/N)), and sets the calculated value to the amplifier output value p_{com} which is the manipulated variable MV for each power amplifier.

The amplifier output command value p_{com} defined by the synthetic output command value/number (P_{com}/N) becomes a command value equal for each power amplifier, and thereby the amplifier outputs become equal to one another. Since each power amplifier has the same output power/power supply efficiency characteristic, the power supply efficiencies of the power amplifiers are equal to one another by equalizing the output power, thereby improving the overall power supply efficiency.

### (a2) Control mode for individual output level

In this setting mode, each power amplifier has unique output power/power supply efficiency characteristic. The control unit uses an output power value determined for the same power supply efficiency as the manipulated variable MV of each power amplifier in the output power/power supply efficiency characteristic unique to each power amplifier to thereby define the amplifier output command value p_{com}. In setting the amplifier output command value p_{com}, the sum of the amplifier output command values p_{com} is defined to be the synthetic output command value P_{com}. By placing a restriction that the amplifier output command values p_{com} are defined so that its sum becomes the synthetic output command value P_{com}, the fluctuation of the output level of the synthetic output is controlled.

### A2-b: Setting mode for manipulated variable MV based on synthetic output feedback value P_{FB}

In this setting mode, the amplifier output conversion value p_{FB} is set as the manipulated variable MV for each power amplifier based on the synthetic output feedback value P_{FB}.

The control unit defines the amplifier output conversion value p_{FB} for each power amplifier based on the synthetic output feedback value P_{FB} of the power synthesis unit, the number N of the power amplifiers, and the output power/power supply efficiency characteristic of each power amplifier. The control unit sets the manipulated variable MV for controlling the amplifier output feedback value p_{fb} detected by each amplifier output detection unit to be the amplifier output conversion value p_{FB}, so as to control a gain of each power amplifier based on the manipulated variable MV. The amplifier output conversion value p_{FB} is an amplifier output which is defined for each power amplifier, and is calculated by dividing the synthetic output feedback value P_{FB} proportionately based on the number N of the power amplifiers and the output power/power supply efficiency characteristic of the power amplifiers.

In the setting based on the synthetic output feedback value P_{FB}, for setting the manipulated variable MV, there are also a setting mode (b1) that makes the outputs of the power amplifiers to have an equal output level and a setting mode (b2) that makes the output of each power amplifier to have an individual output level.

### (b1) Setting mode for equal output level

In this setting mode, the power amplifiers have the same output power/power supply efficiency characteristics, and the output power is set such that the power amplifiers have the same power supply efficiency.

The control unit calculates a uniform output for a value (synthetic output feedback value P_{FB}/the number N of power amplifiers: (P_{FB}/N)) obtained by dividing the synthetic output feedback value P_{FB} by the number N of the power amplifiers, and defines the calculated value as the amplifier output conversion value p_{FB} which is the manipulated variable MV for each power amplifier. Since each power amplifier has the same output power/power supply efficiency characteristics, the power supply efficiencies of the power amplifiers are equal to one another by equalizing the output power, thereby improving the overall power supply efficiency.

### (b2) Control mode for individual output level

In this setting mode, each power amplifier has its unique output power/power supply efficiency characteristic.

The control unit determines the amplifier output conversion values p_{FB} from among the combinations of the amplifier output conversion values p_{FB} of each power amplifier that has the same power supply efficiency in the unique output power/power supply efficiency characteristics of the power amplifiers so that the sum of these amplifier output conversion values p_{FB} becomes the synthetic output feedback value P_{FB}. The amplifier output conversion values p_{FB} are limited such that the sum of these values becomes the synthetic output feedback value P_{FB}, thereby controlling the fluctuation in the output level of the synthetic output.

### A3: Manipulated variable MV

The manipulated variable MV for controlling the output level of the amplifier output of each power amplifier is set according to the form of each power amplifier of the power amplification unit.

(a) In a case where each power amplifier of the power amplification unit consists of a linear amplifier that includes an amplifier with a variable attenuator, the manipulated variable MV is set according to an amount of attenuation Aₜₜ of the amplifier with the variable attenuator.
(b) In a case where each stage of power amplifier of the power amplification unit consists of a switching amplifier that includes a phase control unit, the manipulated variable MV is set according to an amount of phase shift θ and an amount of phase Θ of the phase control unit. The amount of phase shift θ is a control amount for controlling an amount of power in phase shift control, and the amount of phase Θ is a control amount for controlling ON/OFF timing of switching elements included in a phase controller, such as triacs.

It is possible to adjust the gains of each of power amplifier by adjusting a manual adjustment circuit with a variable resistor. However, there are problems that such a process has many adjustment steps, and that it is difficult to automatically respond to the fluctuations in the gains due to the aging of each of power amplifier. The present invention solves these problems by controlling the amount of attenuation Aₜₜ of the amplifier with the variable attenuator as the manipulated variable MV when using the linear amplifier, while controlling the amount of phase shift θ and the amount of phase Θ as the manipulated variables MV when using the switching amplifier.

### A4: Abnormality detection in power amplification unit

Abnormality detection in the power amplification unit is carried out by an abnormality detection mode (a) that is on the basis of the synthetic output feedback value P_{FB} or an abnormality detection mode (b) that is on the basis of the amplifier output feedback value p_{fb}.

### (a) Abnormality detection mode based on synthetic output feedback value P_{FB}

The control unit detects an abnormal state based on the synthetic output feedback value P_{FB}. In one embodiment, the control unit compares the synthetic output feedback value P_{FB} with the synthetic output command value P_{com}, and detects that the power amplification unit is in an abnormal state when the synthetic output feedback value P_{FB} is beyond the acceptable range for the amplifier synthetic output command value P_{com}.

In another mode, the control unit detects that a power amplification unit is in the abnormal state based on a fluctuation amount of the synthetic output feedback value P_{FB} when the fluctuation range of the synthetic output feedback value P_{FB} is beyond the acceptable range.

### (b) Abnormality detection mode based on amplifier output feedback value p_{fb}

The control unit detects the abnormal state based on the amplifier output feedback value p_{fb}. In one embodiment, the control unit compares the amplifier output feedback value p_{fb} with the amplifier output command value p_{com}, and detects that the power amplification unit is in the abnormal state when the amplifier output feedback value p_{fb} is beyond the acceptable range for the amplifier output command value p_{com}.

In another mode, the control unit detects that the power amplification unit is in the abnormal state based on a fluctuation amount of the amplifier output feedback value p_{fb} when the fluctuation range of the amplifier output feedback value p_{fb} is beyond the acceptable range.

### (B): Method for Controlling High-Frequency Power Supply Device

### B1: Control method

A method for controlling a high-frequency power supply device that includes a power amplification unit consisting of multiple power amplifiers arranged to connect in parallel, a distribution unit for distributing a high-frequency signal over the multiple power amplifiers of the power amplification unit, and a power synthesis unit for synthesizing the power of a plurality of amplifier outputs which are amplified in the power amplifiers to thereby output a synthetic output thus obtained:
(a) defines an amplification output reference value p_{ref} (amplifier output command value p_{com} or amplifier output conversion value p_{FB}) for defining an output level of each amplifier output based on a synthetic output command value P_{com} or synthetic output feedback value P_{FB};
(b) compares each amplifier output feedback value p_{fb} with an amplifier output reference value p_{ref} (amplifier output command value p_{com} or amplifier output conversion value p_{FB} of each amplifier output);
(c) based on the comparison, sets a manipulated variable MV for each power amplifier that controls the output level of each amplifier output; and
(d) based on the manipulated variable MV, controls the output level of the amplifier output of each power amplifier.

### B2: Setting of manipulated variable MV

In the setting of the manipulated variable MV, two setting modes are provided, a setting mode (B2-a) based on the synthetic output command value P_{com} and a setting mode (B2-b) based on the synthetic output feedback value P_{FB} for the amplifier output reference value p_{ref} of each power amplifier used as a reference value for the comparison with the amplifier output feedback value p_{fb}.

### B2-a: Setting mode for manipulated variable MV based on synthetic output command value P_{com}

The amplifier output command value p_{com} of each power amplifier is defined based on the synthetic output command value P_{com}, the number N of the power amplifiers, and the output power/power supply efficiency characteristic of each power amplifier, and the defined amplifier output command value p_{com} is used as the amplifier output reference value p_{ref} to thereby set the manipulated variable MV for controlling the amplifier output feedback value p_{fb} to be the amplifier output command value p_{com}.

### B2-b: Setting mode for manipulated variable MV based on synthetic output feedback value P_{FB}

The amplifier output conversion value p_{FB} of each power amplifier is defined based on the synthetic output feedback value P_{FB}, the number N of the power amplifiers, and the output power/power supply efficiency characteristic of each power amplifier, and the defined amplifier output conversion value p_{FB} is used as the amplifier output reference value p_{ref} to thereby set the manipulated variable MV for controlling the amplifier output feedback value p_{fb} to be the amplifier output conversion value p_{FB}.

### [EFFECT OF THE INVENTION]

As described above, the present invention can prevent a decrease in power supply efficiency in the high-frequency power supply device caused by a difference between the output power from the power amplifiers.

### [BRIEF DESCRIPTION OF THE DRAWINGS]

Figure 1 illustrates a schematic configuration of a high-frequency power supply device of the present invention;
Figure 2 illustrates an outline of an operation of the high-frequency power supply device of the present invention;
Figure 3 is a block diagram illustrating an example of a configuration formed by a linear amplifier of the high-frequency power supply device of the present invention;
Figure 4 is a flowchart showing an operation example performed by the linear amplifier of the high-frequency power supply device of the present invention;
Figure 5 illustrates abnormality detection carried out based on a synthetic output feedback value P_{FB} of the present invention;
Figure 6 is a flowchart showing abnormality detection in an amplifier of the present invention;
Figure 7 illustrates abnormality detection carried out based on an amplifier output feedback value p_{fb} of the present invention;
Figure 8 is a flowchart showing abnormality detection of an amplifier output of a power amplifier of the present invention;
Figure 9 is a diagram illustrating a setting for equalizing an amplifier output level and a setting for a manipulated variable MV of the present invention;
Figure 10 is a flowchart illustrating the setting for equalizing the amplifier output level and the setting for the manipulated variable MV of the present invention;
Figure 11 is another diagram illustrating the setting for equalizing the amplifier output level and the setting for the manipulated variable MV of the present invention;
Figure 12 is another flowchart illustrating the setting for equalizing the amplifier output level and the setting for the manipulated variable MV of the present invention;
Figure 13 is a diagram illustrating an individual setting for the amplifier output level and the setting for the manipulated variable MV of the present invention;
Figure 14 is a flowchart illustrating the individual setting for the amplifier output level and the setting for the manipulated variable MV of the present invention;
Figure 15 is a flowchart illustrating an example of setting operation for an amount of attenuation Aₜₜ of the present invention;
Figure 16 is a flowchart illustrating setting operation example 1 of the present invention;
Figure 17 is an operation diagram illustrating setting operation example 1 of the present invention;
Figure 18 is a flowchart illustrating setting operation example 2 of the present invention;
Figure 19 is an operation diagram illustrating setting operation example 2 of the present invention;
Figure 20 is a flowchart illustrating setting operation example 3 of the present invention;
Figure 21 is an operation diagram illustrating setting operation example 3 of the present invention;
Figure 22 is a flowchart illustrating setting operation example 4 of the present invention;
Figure 23 is a block diagram illustrating a configuration example of a switching amplifier of the high-frequency power supply device according to the present invention; and
Figure 24 shows a configuration example of a phase controller which uses a triac.

### [BEST MODE FOR CARRYING OUT THE INVENTION]

### (1) Schematic Configuration of High-Frequency Power Supply Device of the Invention

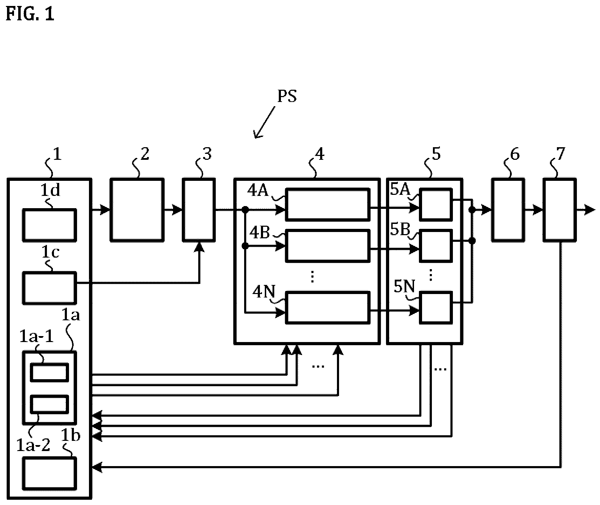

A schematic configuration of a high-frequency power supply device of the present invention will now be described by referring to FIG. 1.

A high-frequency power supply device PS of the present invention includes a control unit 1 that controls the high-frequency power supply device PS, a power amplification unit 4 that consists of multiple power amplifiers 4A, 4B ... 4N which are arranged in parallel, an RF signal unit 2 that generates a high-frequency signal (RF signal), a distribution unit 3 that distributes the high-frequency signal (RF signal) generated by the RF signal unit 2 over power amplifier (4A to 4N) of the power amplification unit 4, a power synthesis unit 6 that synthesizes the power of a plurality of amplifier outputs which are respectively amplified in the power amplifiers (4A to 4N) so as to output a synthetic output, an amplifier output detection unit 5 that detects the amplifier output of each power amplifier (4A to 4N) and feeds amplifier output feedback values p_{fb} back to the control unit 1, and a synthetic output detection unit 7 that is connected between the power synthesis unit 6 and an output end OUT and detects a synthetic output feedback value P_{FB} from separated forward power.

The power amplifiers 4A, 4B ... 4N can be class-AB linear amplifiers or class-D switching amplifiers, by way of example.

The control unit 1 includes an amplifier control unit 1a that controls a gain of each power amplifier (4A to 4N) of the power amplification unit 4, an amplifier abnormality detection unit 1b that detects an abnormality in each power amplifier (4A to 4N), a distribution control unit 1c that controls the distribution unit 3 for distributing the RF signal, and an RF signal setting unit 1d that sets the frequency and the signal level of the high-frequency signal (RF signal).

The amplifier control unit 1a includes an amplifier output reference value setting unit 1a-1 and a manipulated variable setting unit 1a-2. The amplifier output reference value setting unit 1a-1 sets an amplifier output reference value p_{ref} for defining an output level of each amplifier output. The manipulated variable setting unit 1a-2 compares an amplifier output feedback value p_{fb} of each power amplifier (4A to 4N) detected by the amplifier output detection unit 5 with the amplifier output reference value p_{ref} set by the amplifier output reference value setting unit 1a-1, and based the comparison result, sets a manipulated variable MV for controlling the output level of the amplifier output of the power amplifier (4A to 4N) for each power amplifier (4A to 4N). The amplifier output reference value p_{ref} can be an amplifier output command value p_{com} that is set based on a synthetic output command value P_{com} or an amplifier output conversion value p_{FB} that is set based on a synthetic output feedback value P_{FB}.

Each of the power amplifiers 4A, 4B ... 4N of the power amplification unit 4 is operated such that a deviation between the amplifier output feedback value p_{fb} and the amplifier output reference value p_{ref} is decreased based on the manipulated variable MV set for each power amplifier. The manipulated variable MV corresponds to an amplifier gain, and if each amplifier has an attenuator, for instance, the manipulated variable MV is an amount of attenuation Aₜₜ and if each amplifier is a switching amplifier, the manipulated variable MV is an amount of phase shift θ and an amount of phase Θ.

The amplifier control unit 1a controls the output level of the amplifier output of each power amplifier 4A, 4B ... 4N of the power amplification unit 4 based on the manipulated variable MV. The amplifier output reference value setting unit 1a-1 sets the amplifier output reference value p_{ref} based on the synthetic output command value P_{com} for instructing the control unit 1about the output level of power output from the output end OUT by the high-frequency power supply device PS or the synthetic output feedback value P_{FB} detected by the synthetic output detection unit 7. The amplifier output reference value p_{ref} is set based on the amplifier output command value p_{com} for instructing about the output level of the amplifier output from each power amplifier 4A, 4B ... 4N of the power amplification unit 4 or the amplifier output conversion value p_{FB}. The amplifier output reference value p_{ref} is set by the amplifier output reference value setting unit 1a-1 by proportionately distributing the synthetic output command value P_{com} or the synthetic output feedback value P_{FB} based on the number of the power amplifiers 4A, 4B ... 4N and output power/power supply efficiency of each power amplifier 4A, 4B ... 4N.

The amplifier abnormality detection unit 1b detects an abnormal state in an amplifier based on the amplifier output feedback value p_{fb} or the synthetic output feedback value P_{FB}.

The distribution control unit 1c distributes a high-frequency signal (RF signal) over power amplifiers 4A, 4B ... 4N of the power amplification unit 4. In a case where the power amplifier 4A, 4B ... 4N to be driven is changed due to a setting change, the supply of the high-frequency signal (RF signal) is stopped for the power amplifier 4A, 4B ... 4N, which is to be stopped driving. Furthermore, in a case where the amplifier abnormality detection unit 1b detects an abnormality in any of the power amplifiers 4A, 4B ... 4N, the distribution of the high-frequency signal (RF signal) is stopped for the power amplifier, in which the abnormality is detected.

The RF signal setting unit 1d sets the frequency and the signal level of the high-frequency signal (RF signal) based on setting data stored in an internal storage or setting data externally entered.

The synthetic output detection unit 7 separates a reflected wave from a forward wave by means of a directional coupler, for instance, and detects the synthetic output feedback value P_{FB} from the separated forward wave to thereby feed it back to the control unit 1.

### (2) Schematic Operation of High-Frequency Power Supply Device

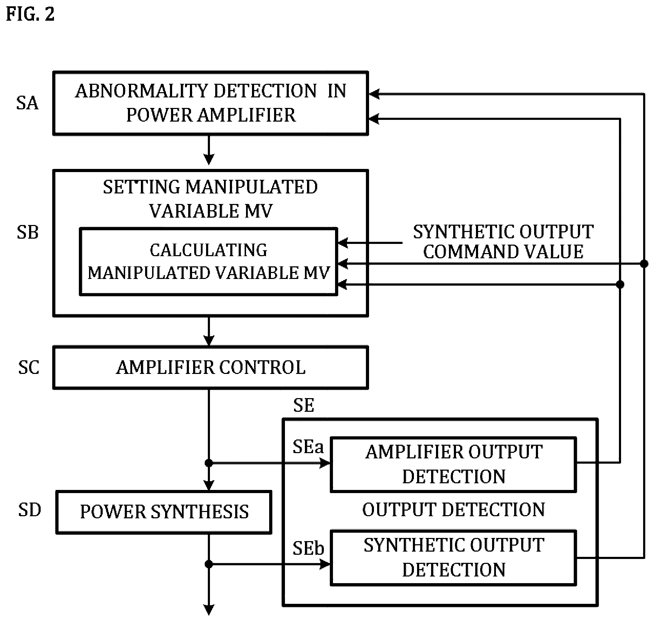

A schematic operation of the high-frequency power supply device of the present invention will be described by referring to FIG. 2.

The high-frequency power supply device of the present invention conducts each operation of abnormality detection in an amplifier (SA), setting of a manipulated variable MV (SB), amplifier control (SC), power synthesis (SD), and output detection (SE), so as to output a synthetic output.

### (SA) Abnormality detection in power amplifier

The control unit 1 monitors the output level of the amplifier output from each power amplifier (4A to 4N) of the power amplification unit 4 or the output level of the synthetic output synthesized in the power synthesis unit 6, and when the output level deviates from a reference level or when the fluctuation range of the output level is out of an acceptable range, determines that the amplifier is in an abnormal state and thereby detect the abnormality in the amplifier.

The abnormality detection for the power amplifiers (4A to 4N) can be set at any given time such as at a predetermined time interval during the operation of the high-frequency power supply device or at a predetermined time such as at the start of the operation.

### (SB) Setting of manipulated variable MV

The detection of an abnormality in any of the power amplifiers (4A to 4N) suggests that there is a difference in the output levels between the power amplifiers (4A to 4N), and also suggests that the power supply efficiencies of the power amplifiers (4A to 4N) are out of proportion to one another, resulting in decrease in the overall power supply efficiency. In order to keep high overall power supply efficiency of the high-frequency power supply device, the power supply efficiencies must be equal between the power amplifiers (4A to 4N).

The manipulated variable MV for controlling the output level of the amplifier output of each power amplifier (4A to 4N) is set such that the power supply efficiency is equal between the power amplifiers (4A to 4N). The manipulated variable MV is, for example, an amount of attenuation Aₜₜ of an attenuator of an amplifier, which has the attenuator, in a linear amplifier and is an amount of phase shift θ and an amount of phase Θ of a phase control unit in a switching amplifier. The amount of phase shift θ is an amount of control for controlling an amount of electricity in phase shift control, and the amount of phase Θ is an amount of control for controlling ON/OFF timing of switching elements, such as triacs, included in the phase controller.

In the setting of the manipulated variable MV, the amplifier output reference value p_{ref} is set as a reference value for the comparison of the output levels of the power outputs from the power amplifiers (4A to 4N).

The amplifier output reference value p_{ref} is set by obtaining the amplifier output command value p_{com} and the amplifier output conversion value p_{FB}. These two values p_{com} and p_{FB} are obtained by dividing proportionately the synthetic output command value P_{com} for providing an instruction about the output level of the power output from the high-frequency power supply device PS or the synthetic output feedback value P_{FB} detected by the synthetic output detection unit 7 based on the number N of the power amplifiers (4A to 4N) and the output power/power supply efficiency characteristics.

The manipulated variable MV is calculated based on a difference between the amplifier output feedback value p_{fb} of each power amplifier (4A to 4N) and the amplifier output reference value p_{ref} (amplifier output command value p_{com} or amplifier output conversion value p_{FB}). The manipulated variable MV corresponds to a gain of each amplifier, and is the amount of attenuation Aₜₜ in the amplifier with the attenuator or is the amount of phase shift θ and the amount of phase Θ in the switching amplifier, for instance.

### (SC) Amplifier control

The control unit 1 controls the output levels of the amplifier outputs in the power amplifiers (4A to 4N) so as to reduce the deviation between the amplifier output feedback value p_{fb} and the amplifier output reference value p_{ref} (amplifier output command value p_{com} or amplifier output conversion value p_{FB}) based on the manipulated variables MV.

### (SD) Power synthesis

The power synthesis unit 6 conducts power synthesis on the amplifier output of each power amplifier (4A to 4N). There are known synthesis circuits (combiners), such as a circuit configuration using a resistor, a circuit configuration using a transformer, and a hybrid circuit. The power synthesis unit 6 of the present invention may employ any synthesis circuit selected to suite output characteristics.

### (SE) Output detection

The output detection includes amplifier output detection (SEa) for detecting the amplifier output of each power amplifier (4A to 4N) and synthetic output detection (SEb) for detecting the synthetic power obtained by the power synthesis.

Each amplifier output feedback value p_{fb} detected by the amplifier output detection (SEa) is used for detecting an abnormality by the abnormality detection (SA) for a power amplifier, and is also used for setting the manipulated variable MV performed by setting the manipulated variable MV (SB). The synthetic output feedback value P_{FB} detected by the synthetic output detection (SEb) is used for detecting an abnormality in a power amplifier by the abnormality detection (SA) for the power amplifier, and is also used for computing the amplifier output command value p_{com} performed by setting the manipulated variable MV (SB).

### (3) High-Frequency Power Supply Device with Linear Amplifiers

In the high-frequency power supply device of the present invention, each power amplifier (4A to 4N) of the power amplification unit 4 can be configured with a class-AB linear amplifier or a class-D switching amplifier.

A description will now be made about a configuration example (3a) and an operation example (3b) of a high-frequency power supply device with linear amplifiers.

### (3a) Configuration example using linear amplifier

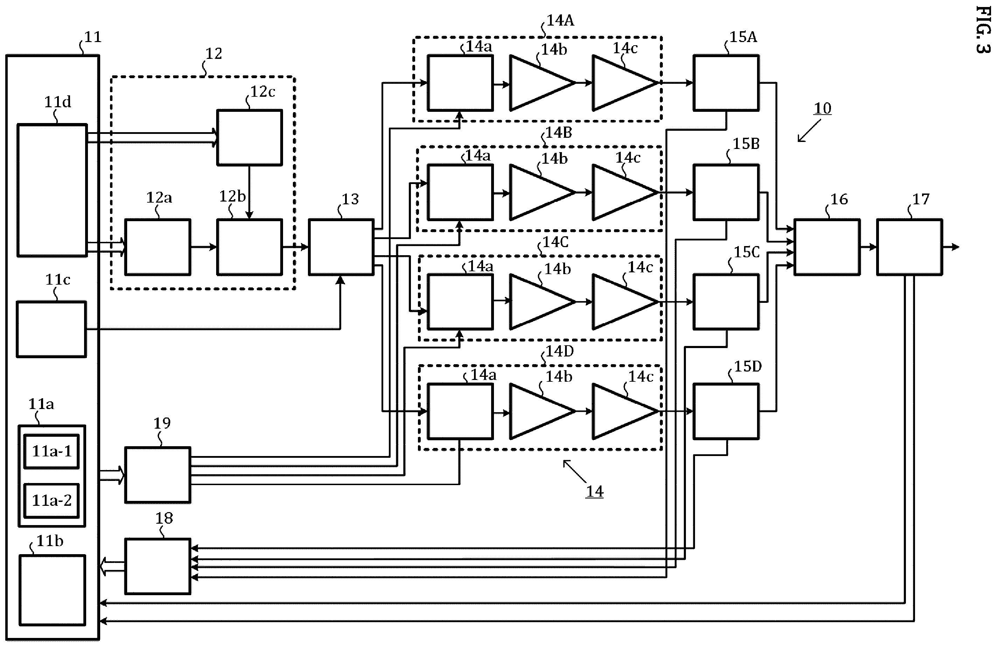

Figure 3 is a block diagram illustrating a configuration example of the high-frequency power supply device using the linear amplifiers according to the present invention.

A high-frequency power supply device 10 includes a control unit 11, an RF signal unit 12, a distribution unit 13, a power amplification unit 14, an amplifier output detection unit 15, a power synthesis unit 16, a synthetic output detection unit 17, an A/D converter 18, and a D/A converter 19.

The RF signal unit 12 includes an RF signal generation unit 12a, a power control amplifier 12b, and a power control interface 12c, and is configured to generate a high-frequency signal (RF signal) which is a high-frequency output signal from the high-frequency power supply device. The high-frequency signal (RF signal) generated in the RF signal generation unit 12a is power-controlled to a predetermined power level by the power control amplifier 12b and is then sent to the distribution unit 13.

The power control amplifier 12b can be composed of a variable attenuator amplifier, by way of example. A gain of the variable attenuator amplifier is controlled according to an amount of attenuation of a control signal input from the power control interface 12c.

The distribution unit 13 distributes the high-frequency signal (RF signal) generated by the RF signal generation unit 12a over multiple power amplifiers 14A, 14B ... 14D of the power amplification unit 14. The reference sign "N" indicates the number of the power amplifiers included in the power amplification unit 14, and is set suitably according to an output level of a high-frequency output which is set in the high-frequency power supply device, output levels of amplifier outputs of the power amplifiers 14A, 14B ... 14D, by way of example. The distribution unit 13 distributes a high-frequency signal (RF signal) over the power amplifiers 14A, 14B ... 14D at a signal level according to the output level of the amplifier outputs of the power amplifiers. In a case where the output levels of the amplifier outputs of the power amplifiers 14A, 14B ... 14D are the same, the signal level of the high-frequency signal (RF signal) distributed over the power amplifiers 14A, 14B ... 14D are the same.

Each power amplifier 14A, 14B ... 14D consists of linear amplifiers, e.g., a variable gain amplifier 14a, a drive amplifier 14b and a terminal stage power amplifier 14c, which are connected in series, and is configured to amplify the power of the high-frequency signal (RF signal) distributed by the distribution unit 13 into an amplifier output. The variable gain amplifier 14a can be composed of a variable attenuator amplifier, for instance, in which a control signal with the amount of attenuation sent from the control unit 11 is input therein via the D/A converter 19 so as to adjust a gain. The driver amplifier 14b amplifies the level of the high-frequency signal (RF signal), of which gain is adjusted by the variable gain amplifier 14a, and the terminal stage power amplifier 14c amplifies the power of the signal amplified by the driver amplifier 14b to the output level set in each power amplifier 14A, 14B ... 14D. Each power amplifier 14A, 14B ... 14D may employ a class-AB linear amplifier, for example.

The power synthesis unit 16 conducts power synthesis on multiple amplifier outputs which are amplified in the power amplifiers 14A, 14B ... 14D, thereby outputting the obtained synthetic output.

The amplifier output detection unit 15 is connected between each of the power amplifiers 14A, 14B ... 14D and the power synthesis unit 16, and is configured to detect the amplifier output of each power amplifiers 14A, 14B ... 14D and return an amplifier output feedback value p_{fb} to the control unit 11 after converting the feedback value p_{fb} into a digital signal via the A/D converter 18.

The synthetic output detection unit 17 is connected between the power synthesis unit 16 and an output end OUT, and is configured to return a synthetic output feedback value P_{FB} to the control unit 11. The synthetic output detection unit 17 can be composed of a directional coupler, and separate forward power traveling to the load and reflected power coming back from a load so as to detect the forward power as the synthetic output feedback value P_{FB}.

The control unit 11 includes an amplifier control unit 11a that controls a gain of the variable gain amplifier 14a of each power amplifier (14A to 14D) of the power amplification unit 14, a power amplifier abnormality detection unit 11b that detects abnormalities in the power amplifiers (14A to 14D), a distribution control unit 11c that controls the distribution of the RF signal conducted by the distribution unit 13, and an RF signal setting unit 11d that sets the frequency and the signal level of a high-frequency signal (RF signal).

The amplifier control unit 11a includes an amplifier output reference value setting unit 11a-1 and a manipulated variable setting unit 11a-2. The amplifier output reference value setting unit 11a-1 sets an amplifier output reference value p_{ref} for defining the output levels of the amplifier outputs of the power amplifiers 14A to 14D. The manipulated variable setting unit 11a-2 compares the amplifier output feedback value p_{fb} detected by the amplifier output detection unit 15 with the amplifier output reference value p_{ref} set by the amplifier output reference value setting unit 11a-1, and based on the comparison result, sets an amount of attenuation Aₜₜ for controlling the output level of the amplifier output of each power amplifier 14A to 14D for each of the power amplifiers 14A to 14D. The variable gain amplifier 14a of each of power amplifiers 14A to 14D is controlled based on the amount of attenuation Aₜₜ set to each variable gain amplifier 14a so as to reduce a deviation between the amplifier output feedback value p_{fb} and the amplifier output reference value p_{ref}. The amount of attenuation Aₜₜ corresponds to an amplifier gain.

On the basis of the amount of attenuation Aₜₜ, the output level of the amplifier output of each of the power amplifiers 14A to 14D of the power amplification unit 14 is controlled. The amplifier output reference value setting unit 11a-1 sets the amplifier output reference value p_{ref} (amplifier output command value p_{com}, amplifier output conversion value p_{FB}) for providing an instruction about the output level of the amplifier output of each power amplifiers 14A to 14D based on a synthetic output command value P_{com} for providing the control unit 11 with an instruction about the output level of the power output from the output end OUT by the high-frequency power supply device PS or the synthetic output feedback value P_{FB} detected by the synthetic output detection unit 17. The setting of the amplifier output reference value p_{ref} (amplifier output command value p_{com}, amplifier output conversion value p_{FB}) conducted by the amplifier output reference value setting unit 11a-1 is carried out by proportionately dividing the synthetic output command value P_{com} or the synthetic output feedback value P_{FB} based on the number N of the power amplifiers 14A to 14D and output power/power supply efficiencies of the power amplifiers 14A to 14D.

The power amplifier abnormality detection unit 11b detects whether each power amplifier is in an abnormal state or not, based on the amplifier output feedback value p_{fb} or the synthetic output feedback value P_{FB}.

The distribution control unit 11c distributes a high-frequency signal (RF signal) over the power amplifiers 14A to 14D of the power amplification unit 14. In a case where a change occurs in the power amplifier to be driven when an abnormality is detected in any of the power amplifiers 14A to 14D, for instance, the distribution control unit 11c conducts control for stopping the supply of the high-frequency signal (RF signal) to the power amplifier in which the abnormality is detected.

The RF signal setting unit 11d sets the frequency and the signal level of the high-frequency signal (RF signal) based on setting data in an internal storage or setting data externally entered.

### (3b) Operation example by linear amplifier

A description will now be made about the following operation examples by a linear amplifier in the high-frequency power supply device of the present invention:
(3b-1) operation for detecting an abnormal state;
(3b-2) operation for setting a manipulated variable MV; and
(3b-3) operation for setting an amount of attenuation Att.

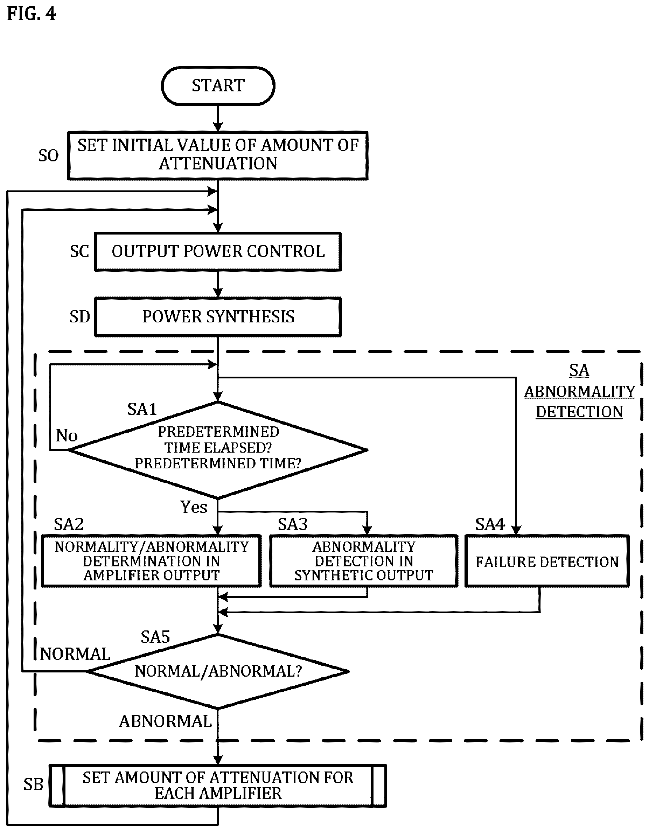

Figure 4 is a flowchart showing an operation example of the linear amplifier, in which steps (SA) to (SE) correspond to those in the flowchart of FIG. 2.

### (3b-1: Operation example of detecting abnormal state in power amplification unit)

An initial value MVo (initial amount of attenuation Aₜₜₒ) of a manipulated variable MV of the amplifier is set in advance (SO), and then the linear amplifier is driven by a gain which is defined by the manipulated variable MV initially set to thereby obtain an amplifier output of each power amplifier and the amplifier outputs are subjected to power synthesis to obtain a synthetic output (SC).

On the basis of the amplifier outputs and the synthetic output obtained in Step (SC), the presence or absence of the abnormal state in the power amplification unit is detected (SA). When the abnormal state is detected in Step (SA) of abnormality detection, the manipulated variable MV (amount of attenuation Aₜₜ) of the linear amplifier of each power amplifier is set (SB), and the linear amplifier is controlled by using the updated manipulated variable MV (amount of attenuation Aₜₜ) (SC).

The detection of the abnormal state in the power amplification unit may be carried out in abnormality determination (SA2, SA3) that is carried out after a lapse of a predetermined time or at a predetermined time point (SA1), or in a failure detection (SA4) that is carried out continuously.

After the lapse of the predetermined time or at the predetermined time point (SA1), the abnormality detection based on the amplifier output feedback values p_{fb} of the power amplifiers (SA2) or the abnormality detection based on the synthetic output feedback value P_{FB} (SA3) is carried out. Alternatively, the failure detection for continuously monitoring the power amplification device (SA4) may be carried out to detect the abnormality.

When an abnormality is detected by the abnormality detection (SA2) or (SA3) or when a failure is detected by the failure detection (SA4) (SA5), the manipulated variable MV for the linear amplifier of each power amplifier is set and updated (SB). In setting the manipulated variable MV, the amount of attenuation Aₜₜ is set as the manipulated variable MV when the amplifier has the attenuator.

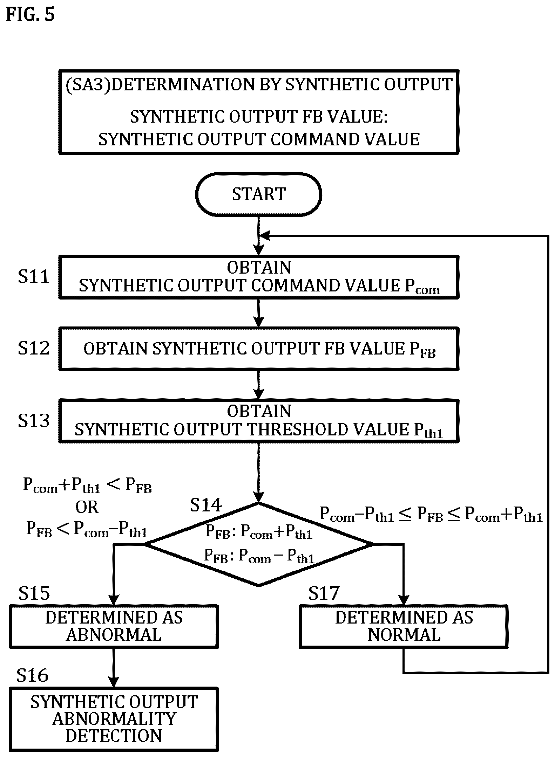

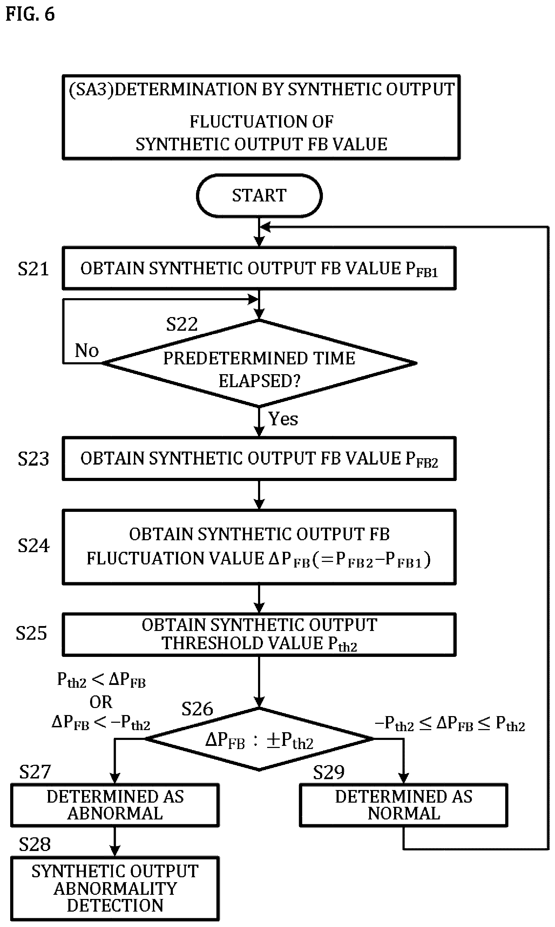

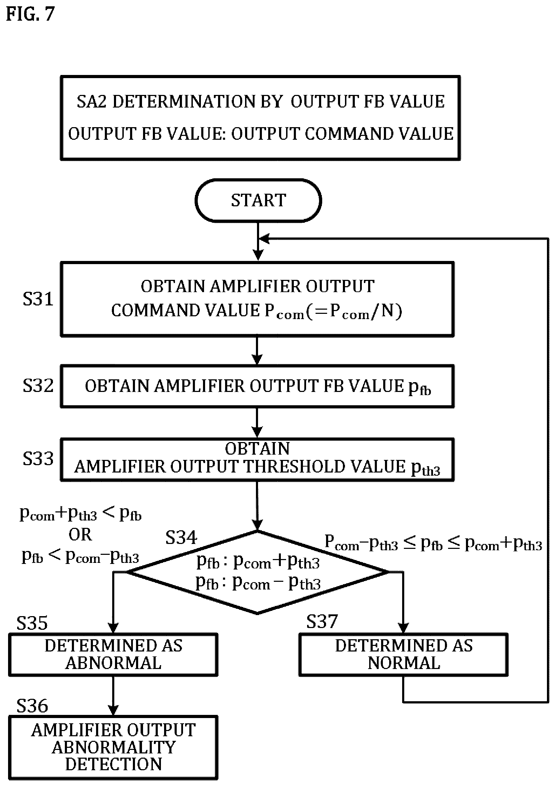

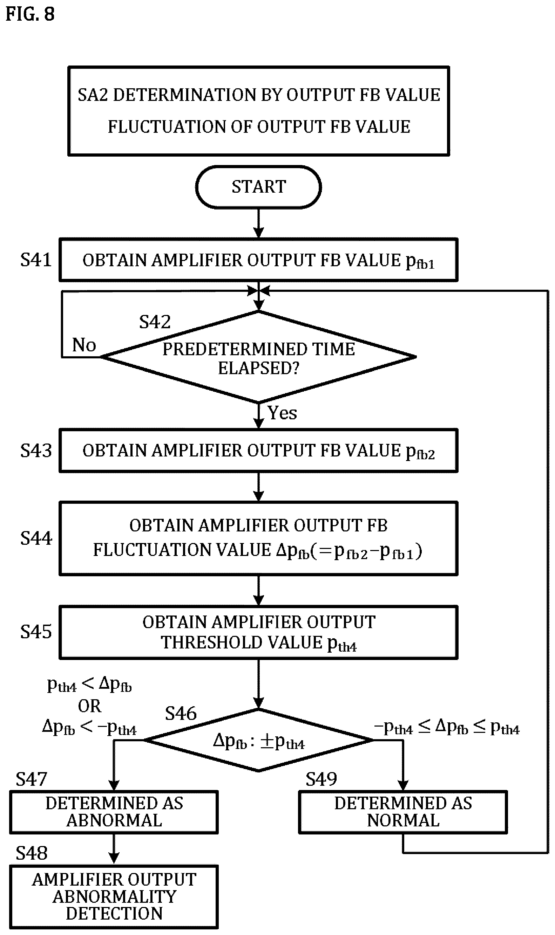

With respect to the abnormality detection on the power amplification unit (SA), the abnormality detection based on the synthetic output feedback value P_{FB} detected by the synthetic output detection unit 17 (SA3) will be described by referring to FIGS. 5 and 6, and the abnormality detection based on the amplifier output feedback value p_{fb} detected by the amplifier output detection unit 15 (SA2) will be described by referring to FIGS. 7 and 8.

### (SA3: Abnormality detection based on synthetic output feedback value P_{FB})

The abnormality detection on the power amplifiers based on the synthetic output feedback value P_{FB} can be implemented in a mode (a) that uses the synthetic output command value P_{com} as a comparison criterion or a mode (b) that uses the fluctuation range of the synthetic output feedback value P_{FB}.

(a) The synthetic output feedback value P_{FB} is compared with the synthetic output command value P_{com} to conduct the abnormality detection on the power amplifiers according to whether or not the synthetic output feedback value P_{FB} is within a predetermined range that is based on the synthetic output command value P_{com}. FIG. 5 is a flowchart showing the abnormality detection on a power amplifier.

The synthetic output command value P_{com} is obtained (S11) and the synthetic output feedback value P_{FB} is obtained (S12) to thereby set a synthetic output threshold value Pₜₕ₁ (S13). When the synthetic output feedback value P_{FB} is within the synthetic output threshold value Pₜₕ₁ that is based on the synthetic output command value P_{com} (S14), it is determined that the synthetic output feedback value P_{FB} is within an acceptable range, and it is therefore determined that the power amplifier is in the normal state (S17). By contrast, when the synthetic feedback value P_{FB} is beyond the synthetic output threshold value Pₜₕ₁ which is based on the synthetic output command value P_{com} (S14), it is determined that the synthetic output feedback value P_{FB} is outside the acceptable range, and it is therefore determined that the power amplifier is in the abnormal state (S15), and thereby the abnormality in the synthetic output is detected (S16).

(b) The abnormality detection is carried out on the power amplifiers based on the fluctuation range of the synthetic output feedback value P_{FB}.

The fluctuation range of the synthetic output feedback value P_{FB} over time is monitored, and the abnormality detection is carried out on the power amplifiers according to whether or not the fluctuation range is within a predetermined range. FIG. 6 is a flowchart showing the abnormality detection on the amplifier.

A synthetic output feedback value P_{FB1} is obtained (S21), and after a lapse of a predetermined time (S22), a synthetic output feedback value P_{FB2} is obtained (S23). A difference ΔP_{FB} (=P_{FB2}-P_{FB1}) between the synthetic output feedback value P_{FB1} and the synthetic output feedback value P_{FB2} thus obtained at two time points is calculated (S24). Then, a synthetic output threshold value Pₜₕ₂ is set (S25), and the difference ΔP_{FB} is compared with the synthetic output threshold value Pₜₕ₂ (S26).

When the difference ΔP_{FB} is within a synthetic output threshold ±Pₜₕ₂, it is determined that the synthetic output feedback value P_{FB} is within the acceptable range, and it is determined that the power amplifier is in the normal state (S29). By contrast, when the difference ΔP_{FB} is beyond the synthetic output threshold value ±Pₜₕ₂, it is determined that the synthetic output feedback value P_{FB} is outside the acceptable range and thus the abnormal detection is carried out (S27), thereby detecting the abnormality in the synthetic output (S28).

### (SA2: Abnormality detection based on amplifier output feedback value p_{fb})

The abnormality detection on the power amplifiers can be implemented by a mode (a) that uses the amplifier output command value p_{com} as a comparison criterion or a mode (b) that uses a fluctuation range of the amplifier output feedback value P_{fb}.

(a) The abnormality detection on the amplifier outputs of the power amplifiers is carried out based on a comparison between the amplifier output feedback value p_{fb} and the amplifier output command value p_{com}.

The amplifier output feedback value p_{fb} is compared with the amplifier output command value p_{com} to conduct the abnormality detection on the power amplifiers according to whether or not the amplifier output feedback value p_{fb} is within a predetermined range that is based on the amplifier output command value p_{com}. FIG. 7 is a flowchart showing the abnormality detection on the amplifier output of a power amplifier.

The amplifier output command value p_{com} is obtained. The amplifier output command value p_{com} is calculated by dividing the synthetic output command value P_{com} by the number N of the amplifiers. The amplifier output command value p_{com} (=P_{com}/N) thus obtained by this computation is an output level obtained by equally dividing an output level instructed by the synthetic output command value P_{com} according to the number N of amplifiers.

The amplifier output feedback value p_{fb} is obtained (S32), and thereby an amplifier output threshold value pₜₕ₃ is set (S33). When the amplifier output feedback value p_{fb} is within the amplifier output threshold value pₜₕ₃ based on the amplifier output command value p_{com} (S34), it is determined that the amplifier output feedback value p_{fb} is within the acceptable range, and it is determined that the power amplifier is in the normal state (S37). By contrast, when the amplifier output feedback value p_{fb} is outside the range of the amplifier output threshold value pₜₕ₃ based on the amplifier output command value p_{com} (S34), it is determined that the amplifier output feedback value p_{fb} is beyond the acceptable range so as to conduct the abnormality determination (S35), thereby detecting the abnormality in the amplifier output of the power amplifier (S36).

(b) The abnormality detection is carried out on the amplifier outputs of the power amplifiers based on the fluctuation range of the amplifier output feedback value p_{fb}.

The fluctuation range of the amplifier output feedback value p_{fb} with time variation is monitored, and the abnormality detection is carried out on the amplifier outputs according to whether or not the fluctuation range is within a predetermined range. FIG. 8 is a flowchart showing the abnormality detection on the amplifier outputs of the power amplifiers.

An amplifier output feedback value p_{fb1} is obtained (S41), and after a lapse of a predetermined time (S42), an amplifier output feedback value p_{fb2} is obtained (S43). A difference Δp_{fb} (=p_{fb2}-p_{fb1}) between the amplifier output feedback value p_{fb1} and the amplifier output feedback value p_{fb2} thus obtained at two time points is calculated (S44). Then, an amplifier output threshold pₜₕ₄ is set (S45), and the difference Δp_{fb} is compared with the amplifier output threshold value pₜₕ₄ (S46).

When the difference Δp_{fb} is within an amplifier output threshold ±pₜₕ₄, it is determined that the amplifier output feedback value p_{fb} is within the acceptable range, and it is determined that the amplifier output is in the normal state (S49). By contrast, when the difference Δp_{fb} is beyond the amplifier output threshold ±pₜₕ₄, it is determined that the amplifier output feedback value p_{fb} is outside the acceptable range so as to conduct the abnormality detection (S47), thereby detecting the abnormality in an amplifier output (S48).

### (3b-2: Setting operation of manipulated variable MV)

The manipulated variable MV is used for adjusting the output level of the amplifier output of each power amplifier to be the setting level. In a case where the setting levels of the amplifier outputs of the power amplifiers are different, the manipulated variables MV are also different, and thus the manipulated variable MV is set according to the output level of the amplifier output set in each power amplifier (amplifier setting level). The manipulated variable MV is therefore set in such a way that the amplifier setting level of each power amplifier is defined first, and then the manipulated variable MV is set based on the amplifier setting level.

### Amplifier setting level:

The amplifier output levels (amplifier setting levels) set in the power amplifiers can be set to values equal in multiple power amplifiers according to the output power/power supply efficiency characteristics of the power amplifiers, or can be set to individual values for respective power amplifiers.

In a case where multiple power amplifiers have the common output power/powers supply efficiency characteristics, the amplifier output levels (amplifier setting levels) set to the power amplifiers are set to be equal so that the power supply efficiencies of the power amplifiers are equal to one another, and thereby the overall power supply efficiency can be enhanced.

In a case where each of the multiple power amplifiers has a unique output power/power supply efficiency characteristic, the output levels of the amplifier outputs of the power amplifiers are individually set so as to equalize the power efficiencies of the power amplifiers, thereby enhancing the overall power supply efficiency.

The amplifier output levels (amplifier setting levels) set in the power amplifiers depend on the number N of the power amplifiers to be driven and the output level of the synthetic output. The number N of the power amplifiers in the drive state is determined according to the state of an amplifier detected by the amplifier abnormality detection. In addition, the output level of the synthetic output can be determined based on the synthetic output command value P_{com} or the synthetic output feedback value P_{FB}.

Now, a description will be made about the setting of the amplifier setting level and the manipulated variable MV (a) in the case of setting the amplifier output levels to the equal value and (b) in the case of setting the amplifier output levels to the individual values.

### (a) Setting amplifier output levels to equal value

In setting the amplifier output levels to the equal values and the manipulated variable MV associated with the setting to the equal value, the amplifier output command value p_{com} of each power amplifier is a reference value for comparing with the amplifier output feedback value p_{fb}. The amplifier output command value p_{com} can be obtained by carrying out setting (a1) based on the synthetic output command value P_{com} or setting (a2) based on synthetic output feedback value P_{FB}.

### (a1) Setting based on synthetic output command value P_{com}

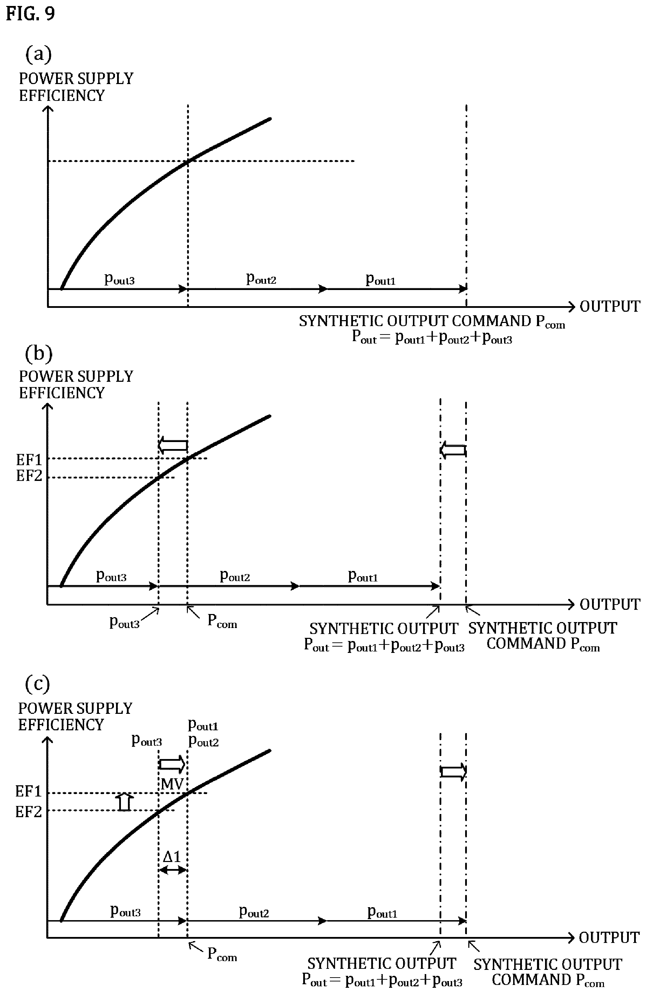

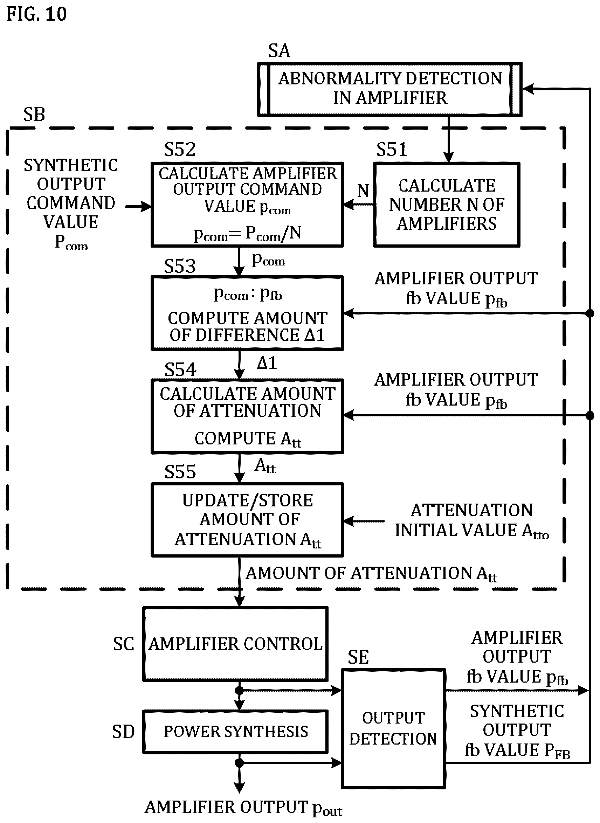

Figures 9 and 10 are a diagram and a flowchart, respectively, illustrating an example of implementing the setting of the amplifier output levels to the equal values and the setting of the manipulated variable MV based on the synthetic output command value P_{com}. FIG. 9 shows output on the horizontal axis and power supply efficiency on the vertical axis. FIG. 9 shows a case where the amplifier outputs of three power amplifiers are equal to one another.

Figure 9(a) shows a state of normal operation, in which the three power amplifiers are outputting amplifier outputs pₒᵤₜ₁, pₒᵤₜ₂ and pₒᵤₜ₃, which are equal in power. In the normal operation, the amplifier output command value p_{com} of each amplifier is P_{com}/3, and the output levels of the amplifier outputs pₒᵤₜ₁, pₒᵤₜ₂ and pₒᵤₜ₃ are equal to one another. Thus, a synthetic output Pₒᵤₜ (=Pₒᵤₜ₁+Pₒᵤₜ₂+Pₒᵤₜ₃) is output. The synthetic output Pₒᵤₜ is at an output level according to the synthetic output command value P_{com}. In this case, the power amplifiers have the same output power/power supply efficiency characteristics, so that power supply efficiencies EF1 of the power amplifiers are equal to one another and the overall power supply efficiency is high.

Figure 9(b) shows an abnormal state in which the amplifier output pₒᵤₜ₃ decreases, and the synthetic output Pₒᵤₜ (=pₒᵤₜ₁+pₒᵤₜ₂+pₒᵤₜ₃) is low due to the synthetic output command value P_{com}. The output levels of the amplifier outputs pₒᵤₜ₁ and pₒᵤₜ₂ are equal to each other based on the amplifier output command values p_{com} (=P_{com}/3) of the respective power amplifiers, but the amplifier output pₒᵤₜ₃ is lower than the amplifier output command value p_{com} (=P_{com}/3) due to the amplifier abnormality. In this case, although the power supply efficiencies of the power amplifiers that output the amplifier outputs pₒᵤₜ₁, pₒᵤₜ₂ are kept to the efficiency EF1, the power supply efficiency of the power amplifier outputting the amplifier output pₒᵤₜ₃ decreases to an efficiency EF2, resulting in the decrease in the overall power supply efficiency.

Figure 9(c) shows a setting of a manipulated variable MV when an abnormality is detected in an amplifier. As shown in FIG. 9(b), when the amplifier output pₒᵤₜ₃ decreases, there is a difference Δ1 between the amplifier output pₒᵤₜ₃ and the amplifier output command value p_{com} (=P_{com}/3). The manipulated variable MV is an amount of gain adjustment of each of the amplifiers for eliminating the difference and raises the amplifier output pₒᵤₜ₃, which has decreased, to the amplifier output command value p_{com} (=P_{com}/3). It allows the amplifier outputs pₒᵤₜ₁, pₒᵤₜ₂, pₒᵤₜ₃ to have equal output levels and the power supply efficiencies of the amplifiers to be the equal efficiency EF1, and thereby the overall power supply efficiency becomes high again.

Figure 10 shows a flowchart in which, after the detection of the abnormality in the amplifier (SA), the manipulated variable MV is set (SB), the amplifier control is carried out based on the manipulated variable MV (SC), and the synthetic output is output by the power synthesis (SD) while carrying out the output detection (SE).

In regard to the setting of the manipulated variable MV based on the synthetic output command value P_{com} (SB), a description will now be made about the case where the amount of attenuation Aₜₜ of the amplifier having the attenuator is used as the manipulated variable MV.

On the basis of the abnormality detection in the amplifier (SA), the number N of power amplifiers to be driven is determined (S51). On the basis of the synthetic output command value P_{com} and the number N of the power amplifiers, the synthetic output command value P_{com} is divided by the number N to calculate the amplifier output command value p_{com} (=P_{com}/N) per power amplifier (S52). Then, a difference Δ1 (=p_{fb}-p_{com}) between the calculated amplifier output command value p_{com} and the amplifier output feedback value p_{fb} is calculated (S53), the amount of attenuation Aₜₜ for eliminating the difference Δ1 is determined (S54), and the determined amount of attenuation Aₜₜ is updated and stored (S55).

A gain using the updated amount of attenuation Aₜₜ is used to conduct the drive control on the power amplifiers (SC), and then the power synthesis is carried out on the amplifier output of each power amplifier (SD). The output detection (SE) detects the amplifier output feedback value p_{fb} of each power amplifier or the synthetic output feedback value P_{FB} obtained by the power synthesis.

### (a2) Setting based on synthetic output feedback value P_{FB}

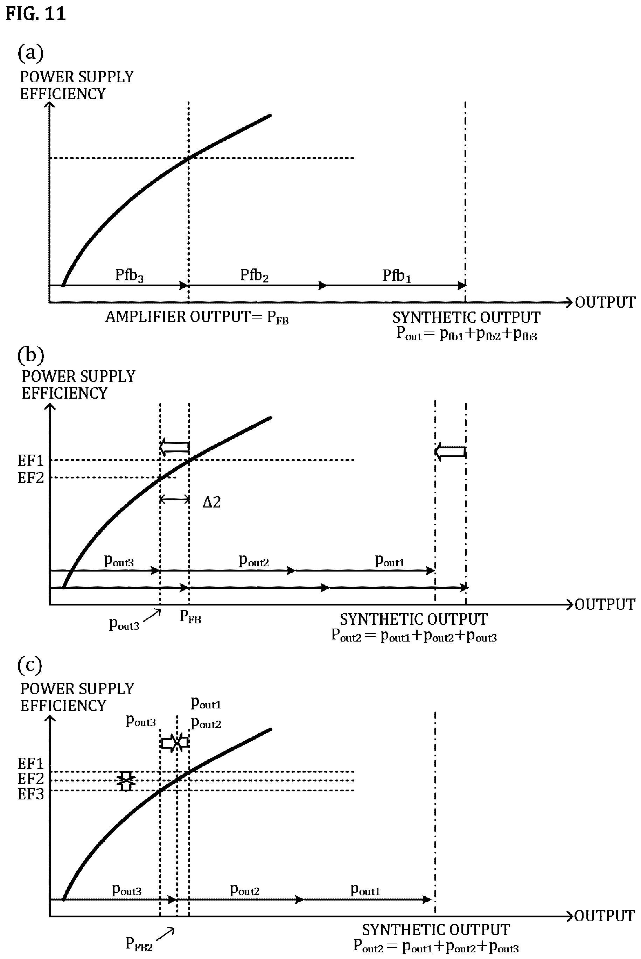

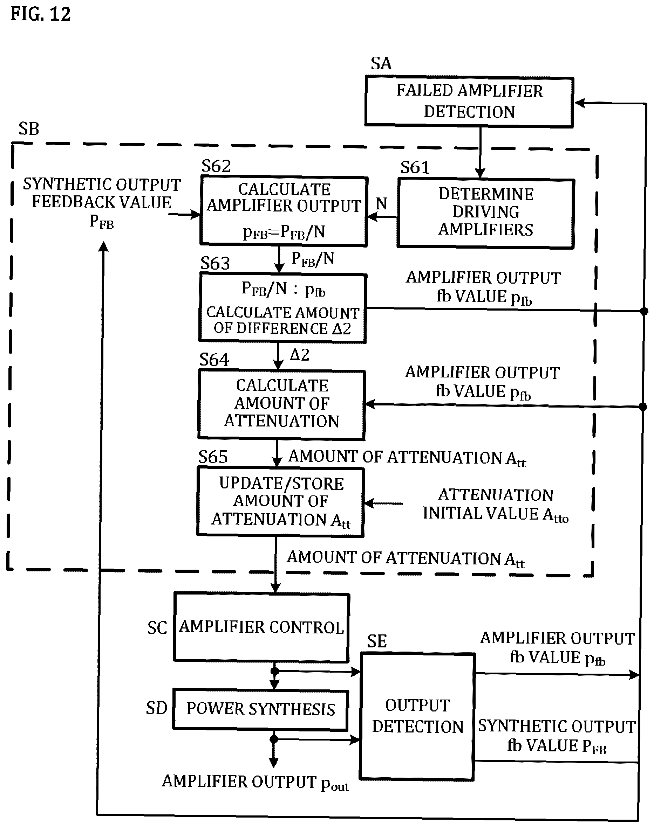

Figures 11 and 12 are a diagram and a flowchart, respectively, illustrating examples to equally set the amplifier output levels and to set the manipulated variable MV based on the synthetic output feedback value P_{FB}. FIG. 11 shows the output on the horizontal axis and the power supply efficiency on the vertical axis. FIG. 11 shows a case where the amplifier outputs of three power amplifiers are equal to one another.

Figure 11(a) shows a state in which the three power amplifiers are operating normally, and amplifier output feedback values p_{fb1}, p_{fb2} and p_{fb3} of these power amplifiers are equal in power. In this case, when the synthetic output feedback value is a value P_{FB1}, the output levels of the amplifier output feedback values p_{fb1}, p_{fb2}, p_{fb3} of respective amplifiers in the normal operation are equivalent to an amplifier output conversion value p_{FB} (=P_{FB1}/3) per amplifier that is obtained by equally dividing the synthetic output feedback value P_{FB1} by the number of the power amplifiers, and a synthetic output Pₒᵤₜ is (p_{fb1}+p_{fb2}+p_{fb3}).

In this case, the power amplifiers have the same output power/power supply efficiency characteristics, so that the power supply efficiencies EF1 of the power amplifiers are equal to one another and the overall power supply efficiency is high.

Figure 11(b) shows an abnormal state in which the amplifier output pₒᵤₜ₃ decreases. In this state, a synthetic output Pₒᵤₜ₂ (=pₒᵤₜ₁+pₒᵤₜ₂+pₒᵤₜ₃) is lower than the synthetic output Pₒᵤₜ₁, namely Pₒᵤₜ, in the normal state. The amplifier outputs pₒᵤₜ₁ and pₒᵤₜ₂ are at the output level of the amplifier output conversion values p_{FB} (=P_{FB1}/3) obtained by equally dividing the synthetic output feedback value P_{FB1} in the normal state by the number of the power amplifiers. In contrast, output pₒᵤₜ₃ is lower than the amplifier output conversion value p_{FB} (=P_{FB1}/3) due to the amplifier abnormality.

In this case, although the power supply efficiencies of the power amplifiers that output the amplifier outputs pₒᵤₜ₁, pₒᵤₜ₂ are kept to the efficiency EF1, the power supply efficiency of the amplifier outputting the amplifier output pₒᵤₜ₃ decreases to the efficiency EF2, resulting in the decrease in the power supply efficiency of the entire power amplification unit.

Figure 11(c) shows a setting of the manipulated variable MV when an amplifier abnormality is detected. As shown in FIG. 11(b), when the amplifier output pₒᵤₜ₃ decreases, there is a difference Δ2 between the amplifier output pₒᵤₜ₃ and the amplifier output conversion value p_{FB} (=P_{FB1}/3) in the normal state. The manipulated variable MV is an amount of adjustment for adjusting a gain of each of the amplifiers to eliminate the difference, and it raises the amplifier output pₒᵤₜ₃, which has decreased, while lowering the amplifier outputs pₒᵤₜ₁ and pₒᵤₜ₂ to have equal output levels, thereby equalizing the power supply efficiencies of all power amplifiers.

The amplifier outputs pₒᵤₜ₁, pₒᵤₜ₂, pₒᵤₜ₃ in this case become an amplifier output conversion value p_{FB2} (=P_{FB2}/3). A synthetic output feedback value P_{FB2} after the adjustment is the sum of the amplifier output pₒᵤₜ₃ which is raised by the adjustment and the amplifier outputs pₒᵤₜ₁, pₒᵤₜ₂ which are lowered by the adjustment.

It leads to the equal output levels of the amplifier outputs pₒᵤₜ₁, pₒᵤₜ₂, pₒᵤₜ₃, and thus the power supply efficiency of each power amplifier equally becomes to an efficiency EF3, and thereby the power supply efficiency of the entire power amplification unit can be increased compared to that before gain adjustment.

Figure 12 shows a flowchart in which after failed amplifier detection (SA), the manipulated variable MV is set (SB), and then amplifier control is carried out based on the manipulated variable MV (SC), thereby outputting a synthetic output by conducting power synthesis (SD) while conducting output detection (SE).

In regard to the setting of the manipulated variable MV based on the synthetic output feedback value P_{FB} (SB), a description will now be made about the case where the amount of attenuation Aₜₜ of the amplifier having the attenuator is applied as the manipulated variable MV.

On the basis of the failed amplifier detection (SA), the power amplifiers to be driven are identified and the number N of the power amplifiers that can be driven is determined (S61). On the basis of the synthetic output feedback value P_{FB} and the number N of the power amplifiers, the synthetic output feedback value P_{FB} is divided by the number N to calculate the amplifier output conversion value p_{FB} (=P_{FB}/N) per power amplifier (S62). Then, a difference Δ2 (=p_{fb}-p_{FB}) between the calculated amplifier output conversion value p_{FB} and the amplifier output feedback value p_{fb} of each power amplifier is calculated (S63), the amount of attenuation Aₜₜ for eliminating the difference Δ2 is determined for each power amplifier to be driven (S64), and the determined amount of attenuation Aₜₜ is updated and stored (S65).

The gain of each power amplifier obtained using the updated amount of attenuation Aₜₜ is used to conduct the drive control on each power amplifier (SC), and then the power synthesis is carried out on the amplifier output of each power amplifier (SD). The output detection (SE) detects the amplifier output feedback value p_{fb} of each power amplifier or the synthetic output feedback value P_{FB} obtained by the power synthesis.

### (b) Individual setting of amplifier output levels

In the individual setting of the amplifier output levels, the amplifier output level of each power amplifier is set such that the multiple power amplifiers are driven with the same power efficiency and the synthetic output obtained by the power synthesis is the synthetic output command value P_{com}. In this case, the amplifier output command value p_{com} of each power amplifier is an index of the amplifier output level of each power amplifier, and the sum of the amplifier output command values p_{com} is set to be the synthetic output command value P_{com}.

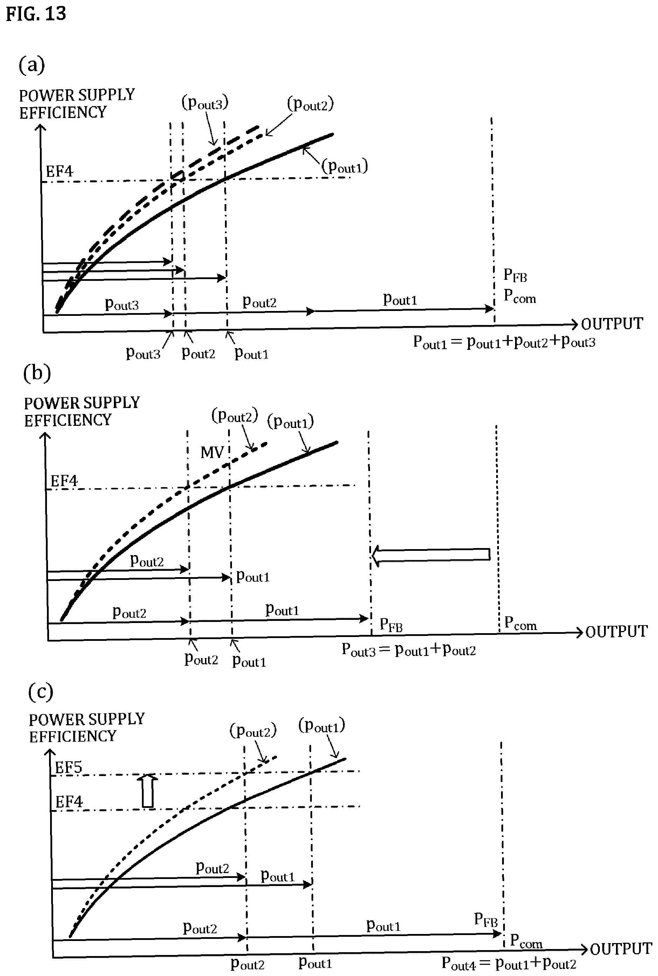

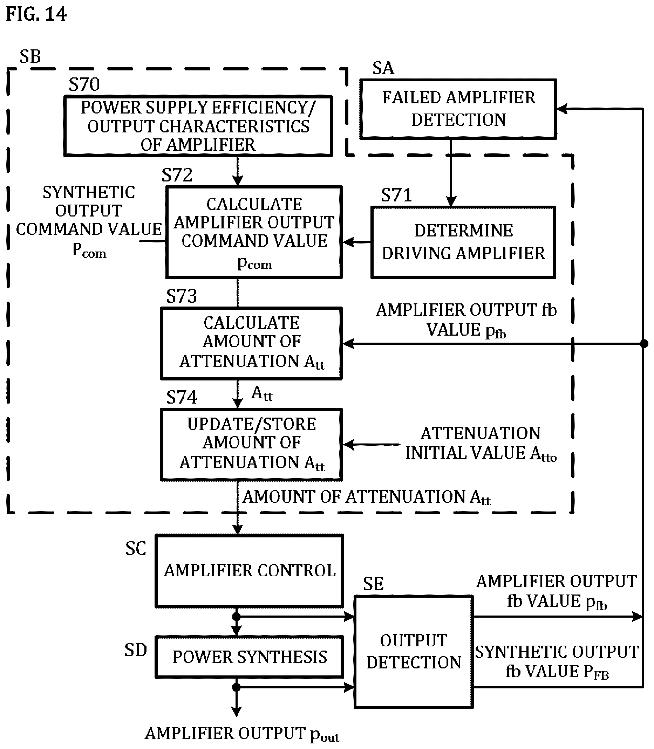

Figures 13 and 14 are a diagram and a flowchart, respectively, illustrating the individual setting of the amplifier output levels and the setting of the manipulated variable MV. FIG. 13 shows the output on the horizontal axis and the power supply efficiency on the vertical axis.

Figure 13(a) shows a state of normal operation, in which three power amplifiers are driven with equal power supply efficiency EF4 and output amplifier outputs pₒᵤₜ₁, pout2, pout3, respectively. A synthetic output Pₒᵤₜ₁ (=pₒᵤₜ₁+pₒᵤₜ₂+pₒᵤₜ₃) obtained by synthesizing the power of the amplifier outputs pₒᵤₜ₁, pₒᵤₜ₂, pₒᵤₜ₃ is at an output level according to a synthetic output command value P_{com}. In a case where each of the power amplifiers has its unique output power/power supply efficiency characteristic, the power amplifiers respectively output different amplifier outputs pₒᵤₜ₁, pₒᵤₜ₂, pₒᵤₜ₃ according to their output power/power supply efficiency characteristics when they have the same power supply efficiency. FIG. 13(a) shows such a state in which the power amplifiers with the same power supply efficiency EF4 output different amplifier outputs pₒᵤₜ₁, pₒᵤₜ₂, pₒᵤₜ₃, respectively.

Figure 13(b) shows an abnormal state in which one of the power amplifiers is stopped and the amplifier output pₒᵤₜ₃ is lost. In this state, although the power supply efficiency is the same in the power amplifiers that output the amplifier outputs pₒᵤₜ₁ and pₒᵤₜ₂, a synthetic output Pₒᵤₜ₃ (=pₒᵤₜ₁+pₒᵤₜ₂) is lower than a synthetic output Pₒᵤₜ₁ in the normal state and deviates from the synthetic output command value P_{com}.

Figure 13(c) shows the setting of the manipulated variable MV when an amplifier abnormality is detected. As shown in FIG. 13(b), when the amplifier output pₒᵤₜ₃ is lost, the synthetic output Pₒᵤₜ₃ is insufficient of the amplifier output by the amplifier output pₒᵤₜ₃ compared to the synthetic output command value P_{com}. In order to compensate for the insufficiency of the amplifier output, the amplifier output pₒᵤₜ₁ and the amplifier output pₒᵤₜ₂ are increased. The increase in the amplifier output pₒᵤₜ₁ and the amplifier output pₒᵤₜ₂ causes an increase in the amplifier output command value p_{com}, and the gain of each power amplifier is adjusted by the manipulated variable MV that corresponds to the increase in the amplifier output command value p_{com}.

In the adjustment of the gains of the power amplifiers, the distribution of the amplifier output pₒᵤₜ₁ and the amplifier output pₒᵤₜ₂ is set such that the power supply efficiencies of the power amplifiers are the same, based on the output power/power supply efficiency characteristics. FIG. 13(c) shows a case where the amplifier output pₒᵤₜ₁ and the amplifier output pₒᵤₜ₂ are distributed so as to have the same power supply efficiency EF5.

Thus, the power amplifiers have the equal power supply efficiency EF5, and thereby the power supply efficiency of the entire power amplification unit can be increased compared to the efficiency before the gain adjustment.

The flowchart in Figure 14 shows that after abnormal amplifier detection (SA), the manipulated variable MV is set (SB), then the amplifier control is carried out based on the manipulated variable MV (SC), and the power synthesis is carried out to output a synthetic output (SD) while carrying out the output detection (SE).

In regard to the setting of the manipulated variable MV for individually setting the amplifier output level for each power amplifier (SB), a description will now be made about a case where the amount of attenuation Aₜₜ of the amplifier having the attenuator is used as the manipulated variable MV.

On the basis of the failed amplifier detection (SA), power amplifiers to be driven are determined (S71). On the basis of the synthetic output command value P_{com} and the output power/power supply efficiency characteristics, the amplifier output command values p_{com} of the power amplifiers to be driven is calculated (S72). The output power/power supply efficiency characteristics is data indicating a relationship between the amplifier output and the power efficiency of each power amplifier, and is also data unique to each of the power amplifiers that form the power amplification unit. The data is stored in readable storage means so that the data is read out according to each of the power amplifiers to be driven and is used for calculating the amplifier output command value p_{com} (S70). Then, based on the amplifier output command value p_{com} of each of the power amplifier calculated in the step (S72), the amount of attenuation Aₜₜ is determined (S73), and the amount of attenuation Aₜₜ thus determined is updated and stored (S74).

On the basis of the gain of each power amplifier determined by using the updated amount of attenuation Aₜₜ, the drive control is carried out on each power amplifier (SC), and thereby the power of the amplifier outputs of the power amplifiers are synthesized (SD). The output detection (SE) is for detecting the amplifier output feedback value p_{fb} of each power amplifier or the synthetic output feedback value P_{FB} obtained by the power synthesis.

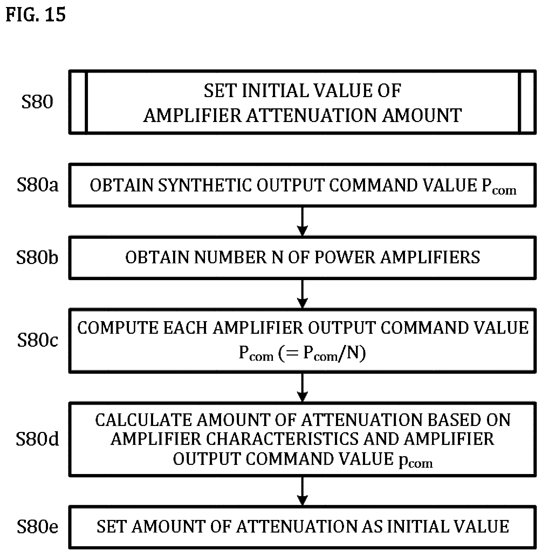

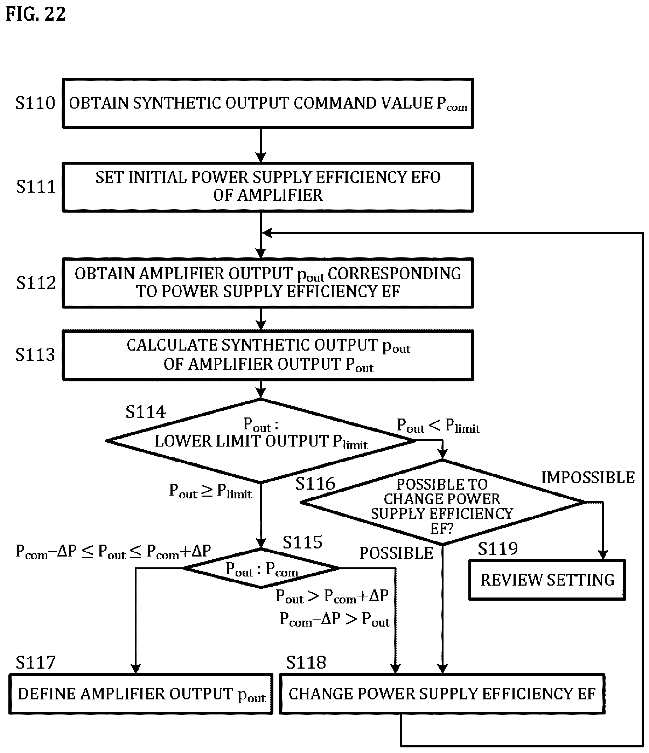

Next, a description will be made about Operation Example 1 to Operation Example 3 for setting the amount of attenuation Aₜₜ by referring to FIGS. 15 to 21, and another description will be made about Operation Example 4 for setting the power supply efficiency EF by referring to FIG. 22.

### (3b-3: Operation for setting amount of attenuation Aₜₜ)

Operation Example 1 to Operation Example 3 show the setting of the amount of attenuation Aₜₜ under the condition that the amplifier output feedback value p_{fb} converges within a predetermined range with the amplifier output command value p_{com} as a reference value.

### (a) Setting operation example 1

Operation Example 1 determines whether the amplifier output feedback value p_{fb} converges within the predetermined range with the amplifier output command value p_{com} as the reference value by comparing the feedback value p_{fb} with the upper limit value of the amplifier output command value p_{com} in a first stage, followed by the comparison with the lower limit value of the amplifier output command value p_{com} in a second stage.

First, an initial amount of attenuation Aₜₜₒ is set (S80). An operation example of setting the initial amount of attenuation Aₜₜₒ will be described by referring to a flowchart shown in FIG. 15.

The synthetic output command value P_{com} is obtained (S80a), and the number N of the power amplifiers forming the power amplification unit is obtained (S80b). On the basis of the obtained synthetic output command value P_{com} and the number N of the amplifiers, the amplifier output command value p_{com} (=P_{com}/N) of each power amplifier is determined (S80c).

On the basis of the output power/power supply efficiency characteristic and the amplifier output command value p_{com} of each power amplifier, the amount of attenuation Aₜₜ is calculated for each power amplifier. In the calculation of the amount of attenuation Aₜₜ, the amount of attenuation Aₜₜ is obtained based on the output power/power supply efficiency characteristic such that the amount of attenuation Aₜₜ satisfies two conditions that a synthetic output value of the amplifier outputs pₒᵤₜ of the power amplifiers becomes the amplifier output command value p_{com} and that the power supply efficiencies of the power amplifiers are the same (S80d). The obtained amount of attenuation Aₜₜ is set as the initial amount of attenuation Aₜₜₒ (S80e).

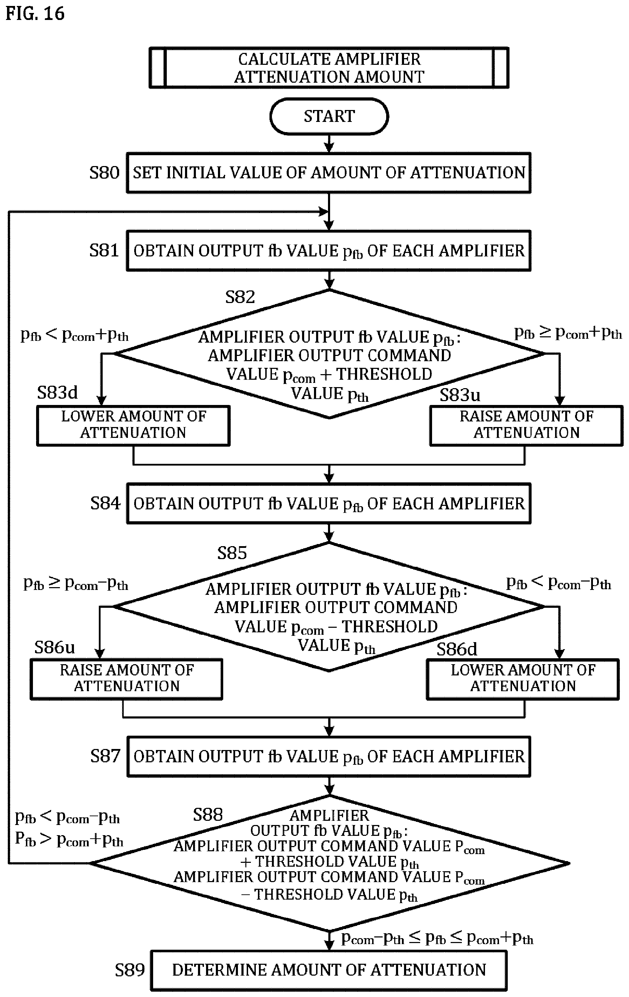

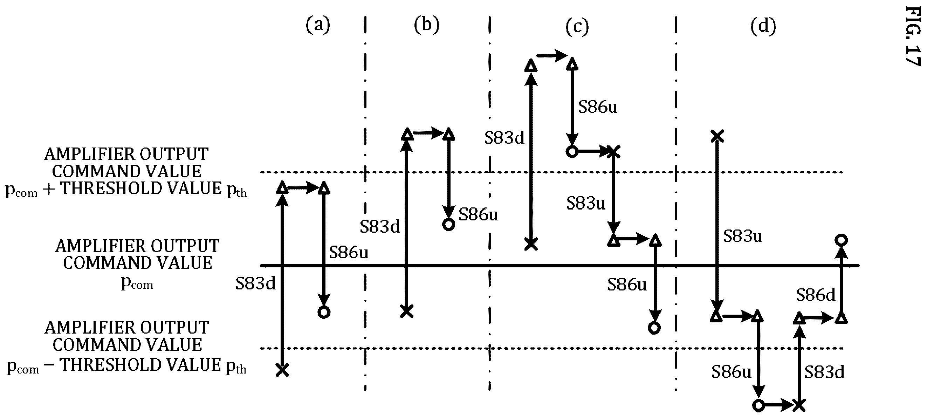

Setting operation example 1 will be described by referring to a flowchart in FIG. 16 and an operation diagram in FIG. 17. Each of the power amplifiers is driven by using the initial amount of attenuation Aₜₜₒ set in the step S80 to obtain the amplifier output feedback value p_{fb} (S81).

In the comparison process in the first stage, the obtained amplifier output feedback value p_{fb} is compared with the upper limit value of the corresponding amplifier output command value p_{com}. As the upper limit value of the amplifier output command value p_{com}, a value (p_{com}+pₜₕ) obtained by adding a threshold value pₜₕ to each amplifier output command value p_{com} is used (S82).

When the amplifier output feedback value p_{fb} does not exceed the value (p_{com}+pₜₕ) (S82), the amount of attenuation Aₜₜ is lowered while raising the amplifier output feedback value p_{fb} (S83d). In contrast, when the amplifier output feedback value p_{fb} is equal to or more than the value (p_{com}+pₜₕ) (S82), the amount of attenuation Aₜₜ is raised while lowering the amplifier output feedback value p_{fb} (S83u). The amount of attenuation Aₜₜ set in the step (S83d) or (S83u) is used to drive the power amplifier to thereby obtain the amplifier output feedback value p_{fb} (S84).

In the comparison process in the second stage, the obtained amplifier output feedback value p_{fb} is compared with the lower limit value of the amplifier output command value p_{com}. As the lower limit value of the amplifier output command value p_{com}, a value (p_{com}-pₜₕ) obtained by subtracting the threshold value pₜₕ from the amplifier output command value p_{com} is used (S85).

When the amplifier output feedback value p_{fb} is equal to or more than the value (p_{com}-pₜₕ) (S85), the amount of attenuation Aₜₜ is raised while lowering the amplifier output feedback value p_{fb} (S86u). In contrast, when the amplifier output feedback value p_{fb} is less than the value (p_{com}-pₜₕ) (S85), the amount of attenuation Aₜₜ is lowered while raising the amplifier output feedback value p_{fb} (S86d). The amount of attenuation Aₜₜ set in the step (S86d) or (S86u) is used to drive the power amplifier to thereby obtain the amplifier output feedback value p_{fb} (S87).

A determination is made about whether the obtained amplifier output feedback value p_{fb} has converged between the upper limit and the lower limit of the amplifier output command value p_{com} (S88).

When the amplifier output feedback value p_{fb} is beyond the upper limit value (p_{com}+pₜₕ) and the lower limit value (p_{com}-pₜₕ) (S88), the procedure goes back to the step (S81) to determine the amount of attenuation Aₜₜ again.

In contrast, when the amplifier output feedback value p_{fb} is between the upper limit value (p_{com}+pₜₕ) and the lower limit value (p_{com}-pₜₕ) (S88), the amount of attenuation Aₜₜ is determined to be the value at this time (S89).

The operation example in Figure 17(a) starts the control with the amplifier output feedback value p_{fb} being less than the lower limit value (p_{com}-pₜₕ) and lowers the amount of attenuation Aₜₜ in the comparison process in the first stage (S83d). Consequently, when the amplifier output feedback value p_{fb} increases to less than the upper limit value (p_{com}+pₜₕ), the amount of attenuation Aₜₜ is raised in the comparison process in the second stage (S86u). As a result, the amplifier output feedback value p_{fb} converges between the upper limit value (p_{com}+pₜₕ) and the lower limit value (p_{com}-pₜₕ), and thereby the amount of attenuation Aₜₜ is set.

The operation example in Figure 17(b) starts the control with the amplifier output feedback value p_{fb} exceeding the lower limit value (p_{com}-pₜₕ) and lwers the amount of attenuation Aₜₜ in the comparison process in the first stage (S83d). Consequently, when the amplifier output feedback value p_{fb} increases beyond the upper limit value (p_{com}+pₜₕ), the amount of attenuation Aₜₜ is raised in the comparison in the second stage (S86u). As a result, the amplifier output feedback value p_{fb} converges between the upper limit value (p_{com}+pₜₕ) and the lower limit value (p_{com}-pₜₕ), and thereby the amount of attenuation Aₜₜ is set.

The operation example in Figure 17(c) starts the control with the amplifier output feedback value p_{fb} being between the upper limit value (p_{com}+pₜₕ) and the lower limit value (p_{com}-pₜₕ) and lowers the amount of attenuation Aₜₜ in the comparison process in the first stage (S83d). Consequently, when the amplifier output feedback value p_{fb} increases beyond the upper limit value (p_{com}+pₜₕ), the amount of attenuation Aₜₜ is raised in the comparison in the second stage (S86u). In a case where the amplifier output feedback value p_{fb} is not below the upper limit value (p_{com}+pₜₕ), the comparison process in the first stage is performed again to raise the amount of attenuation Aₜₜ (S83u). Consequently , when the amplifier output feedback value p_{fb} is not below the lower limit value (p_{com}-pₜₕ), the amount of attenuation Aₜₜ is raised in the comparison process in the second stage (S86u). As a result, the amplifier output feedback value p_{fb} converges between the upper limit value (p_{com}+pₜₕ) and the lower limit value (p_{com}-pₜₕ), and thereby the amount of attenuation Aₜₜ is set.

The operation example in Figure 17(d) starts the control with the amplifier output feedback value p_{fb} exceeding the upper limit value (p_{com}+pₜₕ) and raises the amount of attenuation Aₜₜ in the comparison process in the first stage (S83u). Consequently, when the amplifier output feedback value p_{fb} is not below the lower limit value (p_{com}-pₜₕ), the amount of attenuation Aₜₜ is raised in the comparison in the second stage (S86u). In a case where the amplifier output feedback value p_{fb} is below the lower limit value (p_{com}-pₜₕ), the comparison process in the first stage is performed again to lower the amount of attenuation Aₜₜ (S83d). Consequently, when the amplifier output feedback value p_{fb} does not exceed the lower limit value (p_{com}-pₜₕ), the amount of attenuation Aₜₜ is lowered in the comparison process in the second stage (S86d). As a result, the amplifier output feedback value p_{fb} converges between the upper limit value (p_{com}+pₜₕ) and the lower limit value (p_{com}-pₜₕ), and thereby the amount of attenuation Aₜₜ is set.

### (b) Setting operation example 2

Setting operation example 2 determines whether the amplifier output feedback value p_{fb} converges within the predetermined range with the amplifier output command value p_{com} being the reference value by comparing the feedback value p_{fb} with the lower limit value of the amplifier output command value p_{com} in a first stage, followed by the comparison with the upper limit value of the amplifier output command value p_{com} in a second stage.

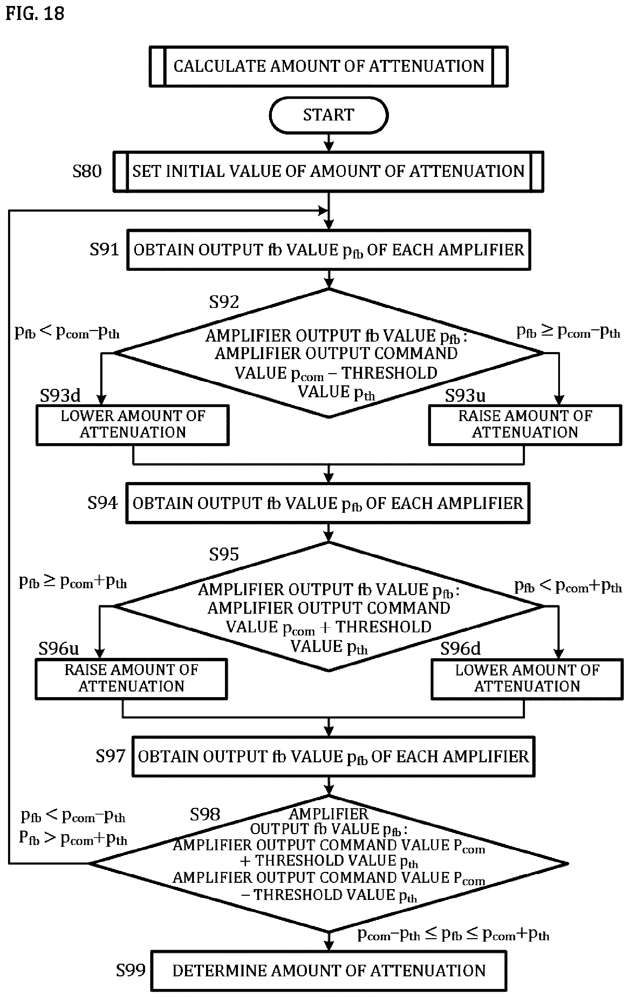

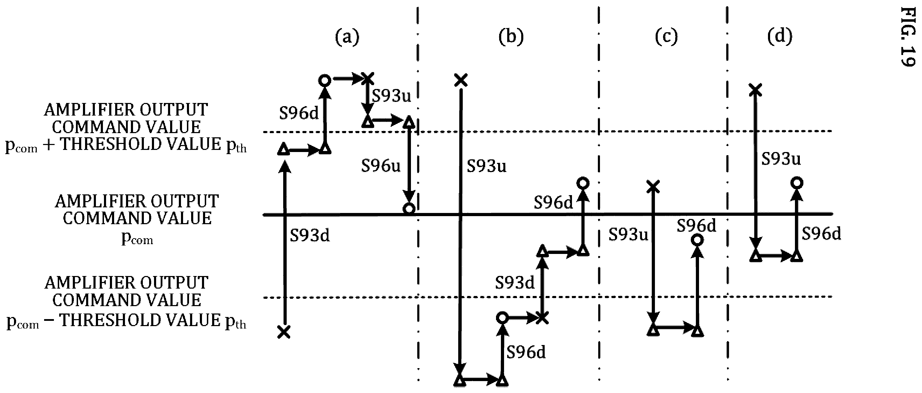

Setting operation example 2 will be described by referring to a flowchart shown in FIG. 18 and an operation diagram shown in FIG. 19. As with the case of Operation Example 1, the initial amount of attenuation Aₜₜₒ set in the step S80 is set in this example, and the power amplifiers are driven by using the initial amount of attenuation Aₜₜₒ so as to obtain the amplifier output feedback value p_{fb} (S91).

In the comparison process in the first stage, the obtained amplifier output feedback value p_{fb} is compared with the lower limit value of the amplifier output command value p_{com}. As the lower limit value of the amplifier output command value, a value (p_{com}-pₜₕ) is used, which is obtained by subtracting the threshold value pₜₕ from the amplifier output command value p_{com} (S92).

When the amplifier output feedback value p_{fb} is less than the value (p_{com}-pₜₕ) (S92), the amount of attenuation Aₜₜ is lowered and the amplifier output feedback value p_{fb} is raised (S93d). In contrast, when the amplifier output feedback value p_{fb} is equal to or more than the value (p_{com}-pₜₕ) (S92), the amount of attenuation Aₜₜ is raised and the amplifier output feedback value p_{fb} is lowered (S93u). The power amplifiers are driven by using the amount of attenuation Aₜₜ set in the step (S93d) or (S93u) so as to obtain the amplifier output feedback value p_{fb} (S94).

In the comparison process in the second stage, the obtained amplifier output feedback value p_{fb} is compared with the upper limit value of the amplifier output command value p_{com}. As the upper limit value of the amplifier output command value, a value (p_{com}+pₜₕ) is used, which is obtained by adding the threshold value pₜₕ to the amplifier output command value p_{com} (S95).

When the amplifier output feedback value p_{fb} is equal to or more than the value (p_{com}+pₜₕ) (S95), the amount of attenuation Aₜₜ is raised and the amplifier output feedback value p_{fb} is lowered (S96u). In contrast, when the amplifier output feedback value p_{fb} is less than the value (p_{com}+pₜₕ) (S95), the amount of attenuation Aₜₜ is lowered and the amplifier output feedback value p_{fb} is raised (S96d). The power amplifiers are driven by using the amount of attenuation Aₜₜ set in the step (S96d) or (S96u) so as to obtain the amplifier output feedback value p_{fb} (S97).

A determination is made about whether the obtained amplifier output feedback value p_{fb} has converged between the upper limit and the lower limit of the amplifier output command value p_{com} (S98).

When the amplifier output feedback value p_{fb} is beyond the upper limit value (p_{com}+pₜₕ) and the lower limit value (p_{com}-pₜₕ) (S98), the procedure goes back to the step (S91) to determine the amount of attenuation Aₜₜ again.

In contrast, when the amplifier output feedback value p_{fb} is between the upper limit value (p_{com}+pₜₕ) and the lower limit value (p_{com}-pₜₕ) (S98), the amount of attenuation Aₜₜ is determined to be the value at this time (S99).

The setting operation example in Figure 19(a) starts the control with the amplifier output feedback value p_{fb} being less than the lower limit value (p_{com}-pₜₕ) and lowers the amount of attenuation Aₜₜ in the comparison process in the first stage (S93d). Consequently, when the amplifier output feedback value p_{fb} increases to less than the upper limit value (p_{com}+pₜₕ), the amount of attenuation Aₜₜ is lowered in the comparison process in the second stage (S96d). In a case where the amplifier output feedback value p_{fb} exceeds the upper limit value (p_{com}+pₜₕ), the comparison process in the first stage is performed again to raise the amount of attenuation Aₜₜ (S93u). Consequently, when the amplifier output feedback value p_{fb} still exceeds the upper limit value (p_{com}+pₜₕ), the amount of attenuation Aₜₜ is raised in the comparison process in the second state (S96u). As a result, the amplifier output feedback value p_{fb} converges between the upper limit value (p_{com}+pₜₕ) and the lower limit value (p_{com}-pₜₕ), and thereby the amount of attenuation Aₜₜ is set.

The setting operation example in Figure 19(b) starts the control with the amplifier output feedback value p_{fb} exceeding the upper limit value (p_{com}+pₜₕ) and raises the amount of attenuation Aₜₜ in the comparison process in the first stage (S93u). Consequently, when the amplifier output feedback value p_{fb} falls below the lower limit value (p_{com}-pₜₕ), the amount of attenuation Aₜₜ is lowered in the comparison in the second stage (S96d). In a case where the amplifier output feedback value p_{fb} does not exceed the lower limit value (p_{com}-pₜₕ), the comparison process in the first stage is performed again to lower the amount of attenuation Aₜₜ (S93d). Consequently, when the amplifier output feedback value p_{fb} exceeds the lower limit value (p_{com}-pₜₕ), the amount of attenuation Aₜₜ is lowered in the comparison process in the second stage (S96d). As a result, the amplifier output feedback value p_{fb} converges between the upper limit value (p_{com}+pₜₕ) and the lower limit value (p_{com}-pₜₕ), and thereby the amount of attenuation Aₜₜ is set.

The setting operation example in Figure 19(c) starts the control with the amplifier output feedback value p_{fb} being between the upper limit value (p_{com}+pₜₕ) and the lower limit value (p_{com}-pₜₕ) and raises the amount of attenuation Aₜₜ in the comparison process in the first stage (S93u). Consequently, when the amplifier output feedback value p_{fb} falls below the lower limit value (p_{com}-pₜₕ), the amount of attenuation Aₜₜ is lowered in the comparison in the second stage (S96d). As a result, the amplifier output feedback value p_{fb} converges between the upper limit value (p_{com}+pₜₕ) and the lower limit value (p_{com}-pₜₕ), and thereby the amount of attenuation Att is set.

The operation example in Figure 19(d) starts the control with the amplifier output feedback value p_{fb} exceeding the upper limit value (p_{com}+pₜₕ) and raises the amount of attenuation Aₜₜ in the comparison process in the first stage (S93u). Consequently, when the amplifier output feedback value p_{fb} is between the upper limit value (p_{com}+pₜₕ) and the lower limit value (p_{com}-pₜₕ), the amount of attenuation Aₜₜ is lowered in the comparison in the second stage (S96d). As a result, the amplifier output feedback value p_{fb} converges between the upper limit value (p_{com}+pₜₕ) and the lower limit value (p_{com}-pₜₕ), and thereby the amount of attenuation Aₜₜ is set.

### (c) Setting operation example 3

Setting operation example 3 determines whether the amplifier output feedback value p_{fb} converges within the predetermined range with the amplifier output command value p_{com} being the reference value by comparing the feedback value p_{fb} with the range between the upper limit of the amplifier output command value p_{com} and the lower limit of the amplifier output command value p_{com}.

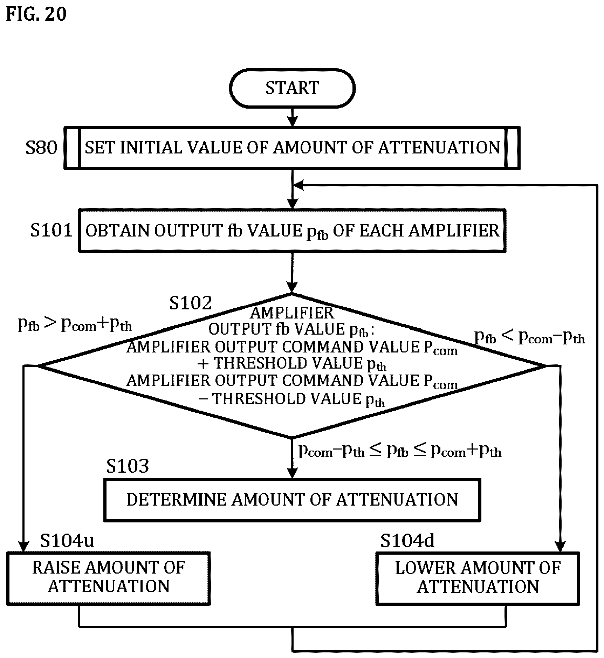

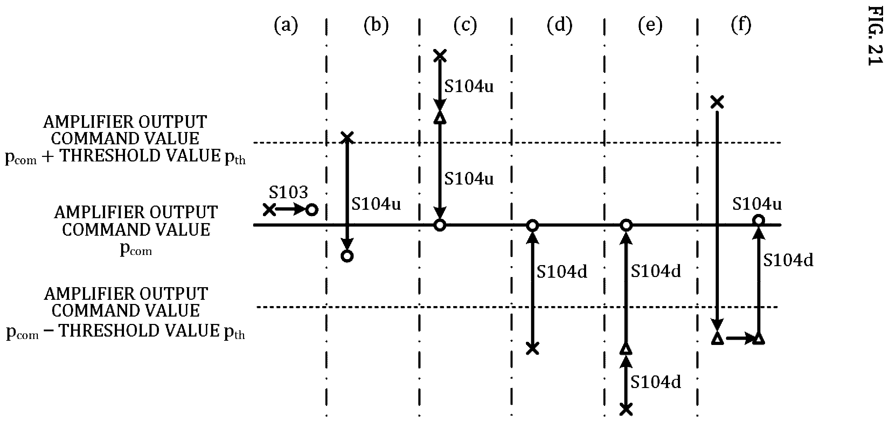

Setting operation example 3 will be described by referring to a flowchart shown in FIG. 20 and an operation diagram shown in FIG. 21. As with the case of Operation Example 1, the initial amount of attenuation Aₜₜₒ set in the step S80 is set in this example, and the power amplifiers are driven by using the initial amount of attenuation Aₜₜₒ so as to obtain the amplifier output feedback value p_{fb} (S101).

A determination is made about whether the obtained amplifier output feedback value p_{fb} is between the upper limit of the amplifier output command value p_{com} and the lower limit of the amplifier output command value p_{com} so as to obtain the amount of attenuation of the power amplifiers. As the lower limit of the amplifier output command value p_{com}, a value (p_{com}-pₜₕ) is used, which is obtained by subtracting the threshold value pₜₕ from the amplifier output command value p_{com}, and as the upper limit of the amplifier output command value p_{com}, a value (p_{com}+pₜₕ) is used, which is obtained by adding the threshold value pₜₕ to the amplifier output command value p_{com} (S102).

When the amplifier output feedback value p_{fb} is between the upper limit value of the amplifier output command value p_{com} and the lower limit value of the amplifier output command value p_{com}, the amount of attenuation Aₜₜ is determined to be the value at this time (S103).

When the amplifier output feedback value p_{fb} exceeds the upper limit value (p_{com}+pₜₕ) of the amplifier output command value p_{com}, the amount of attenuation is raised (S104u), and when the amplifier output feedback value p_{fb} is smaller than the lower limit value (p_{com}-pₜₕ) of the amplifier output command value p_{com}, the amount of attenuation is lowered (S104d).

According to the amount of attenuation defined in the step (S104d) or (S104u), the procedure goes back to the step (S101) to drive the power amplifiers, thereby obtaining the amplifier output feedback value p_{fb}, and the processes in the step (S102) and the subsequent steps are repeated again to determine the amount of attenuation Aₜₜ.

In the setting operation example shown in Figure 21(a), the obtained amplifier output feedback value p_{fb} is between the upper limit value (p_{com}+pₜₕ) and the lower limit value (p_{com}-pₜₕ) (S102), and thus the amountatthis time is defined as the amount of attenuation Aₜₜ (S103).

In the setting operation example shown in Figure 21(b), the obtained amplifier output feedback value p_{fb} exceeds the upper limit value (p_{com}+pₜₕ) (S102), and thus the amount of attenuation is raised (S104u). When the amplifier output feedback value p_{fb} obtained according to the raised amount of attenuation falls between the upper limit value (p_{com}+pₜₕ) and the lower limit value (p_{com}-pₜₕ) (S102), the amount at this time is defined as the amount of attenuation Aₜₜ (S103).

In the setting operation example shown in Figure 21(c), the obtained amplifier output feedback value p_{fb} exceeds the upper limit value (p_{com}+pₜₕ) (S102), and thus the amount of attenuation is raised (S104u). In a case where the amplifier output feedback value p_{fb} obtained according to the raised amount of attenuation still exceeds the upper limit value (p_{com}+pₜₕ) (S102), the amount of attenuation Aₜₜ is raised again (S104u). When the amplifier output feedback value p_{fb} obtained according to the raised amount of attenuation falls between the upper limit value (p_{com}+pₜₕ) and the lower limit value (p_{com}-pₜₕ) (S102), the amount at this time is defined as the amount of attenuation Aₜₜ (S103).

In the setting operation example shown in Figure 21(d), the obtained amplifier output feedback value p_{fb} is below the lower limit value (p_{com}-pₜₕ) (S102), and thus the amount of attenuation is lowered (S104d). When the amplifier output feedback value p_{fb} obtained according to the lowered amount of attenuation falls between the upper limit value (p_{com}+pₜₕ) and the lower limit value (p_{com}-pth) (S102), the amount at this time is defined as the amount of attenuation Aₜₜ (S103).

In the setting operation example shown in Figure 21(e), the obtained amplifier output feedback value p_{fb} is below the lower limit value (p_{com}-pₜₕ) (S102), and thus the amount of attenuation is lowered (S104d). When the amplifier output feedback value p_{fb} obtained according to the lowered amount of attenuation is still below the lower limit value (p_{com}-pₜₕ) (S102), the amount of attenuation is lowered again (S104d).

When the amplifier output feedback value p_{fb} obtained according to the lowered amount of attenuation falls between the upper limit value (p_{com}+pₜₕ) and the lower limit value (p_{com}-pₜₕ) (S102), the amount at this time is defined as the amount of attenuation Aₜₜ (S103).

In the setting operation example shown in Figure 21(f), the amplifier output feedback value p_{fb} exceeds the upper limit value (p_{com}+pₜₕ) (S102), and thus the amount of attenuation is raised (S104u). Consequently, when the amplifier output feedback value p_{fb} obtained according to the raised amount of attenuation is below the lower limit value (p_{com}-pₜₕ) (S102), the amount of attenuation is lowered (S104d). As a result, when the amplifier output feedback value p_{fb} obtained according to the lowered amount of attenuation falls between the upper limit value (p_{com}+pₜₕ) and the lower limit value (p_{com}-pₜₕ) (S102), the amount at this time is defined as the amount of attenuation Aₜₜ (S103).

### (3b-4: Operation for setting power supply efficiency EF)

Setting operation example 4 relates to the setting of the power supply efficiency EF under the condition that the synthetic output Pₒᵤₜ converges in a predetermined range in which the synthetic output command value P_{com} is used as a reference value.

Setting operation example 4 will be described by referring to a flowchart shown in FIG. 22.

For setting the power supply efficiency EF preferable to the synthetic output command value P_{com}, a criterial synthetic output command value P_{com} is obtained (S110) to set an initial power efficiency EFO of each power amplifier (S111).

On the basis of the output power/power supply efficiency characteristics of each power amplifier, the amplifier output pₒᵤₜ is determined for each of the power amplifiers which correspond to the initial power supply efficiency EFO. In a case where the multiple power amplifiers included in the power amplification unit have the same output power/power supply efficiency characteristics, the amplifier outputs pₒᵤₜ of the power amplifiers have the same output power (S112). The amplifier outputs pₒᵤₜ thus obtained are added to calculate the synthetic output Pₒᵤₜ (S113).

A lower limit output Pₗᵢₘᵢₜ of the synthetic output required for the power amplification unit is set, and a determination is made about whether the synthetic output Pₒᵤₜ calculated in the step S113 satisfies the lower limit output Pₗᵢₘᵢₜ (S114).

When the calculated synthetic output Pₒᵤₜ is equal to or more than the lower limit output Pₗᵢₘᵢₜ, it is determined that the required minimum power output can be obtained, and a determination is made about whether the synthetic output satisfies the synthetic output command value P_{com}. This determination can be based on whether or not the synthetic output Pₒᵤₜ is within tolerance ΔP of the synthetic output command value P_{com} (S115).

When the calculated synthetic output Pₒᵤₜ is within the tolerance ΔP of the synthetic output command value P_{com}, the output pₒᵤₜ determined in the step S112 is set as the amplifier output pₒᵤₜ of each power amplifier (S117).

When the calculated synthetic output Pₒᵤₜ is not within the tolerance ΔP of the synthetic output command value P_{com}, the power supply efficiency EF is changed (S118), and then the processes in the step (S112) and the subsequent steps are repeated.

In a case where the calculated synthetic output Pₒᵤₜ does not exceed the lower limit output Pₗᵢₘᵢₜ in the step (S114), the power supply efficiency EF is changed if it is possible (S118), and the processes in the step (S112) and the subsequent steps are repeated. In contrast, if the power supply efficiency EF cannot be changed, a satisfactory synthetic output Pₒᵤₜ will not be obtained based on the current setting of the power amplifiers, and it is therefore necessary to readjust the setting of the power amplifiers (S119).

### (4) High-Frequency Power Supply Device employing Switching Amplifiers

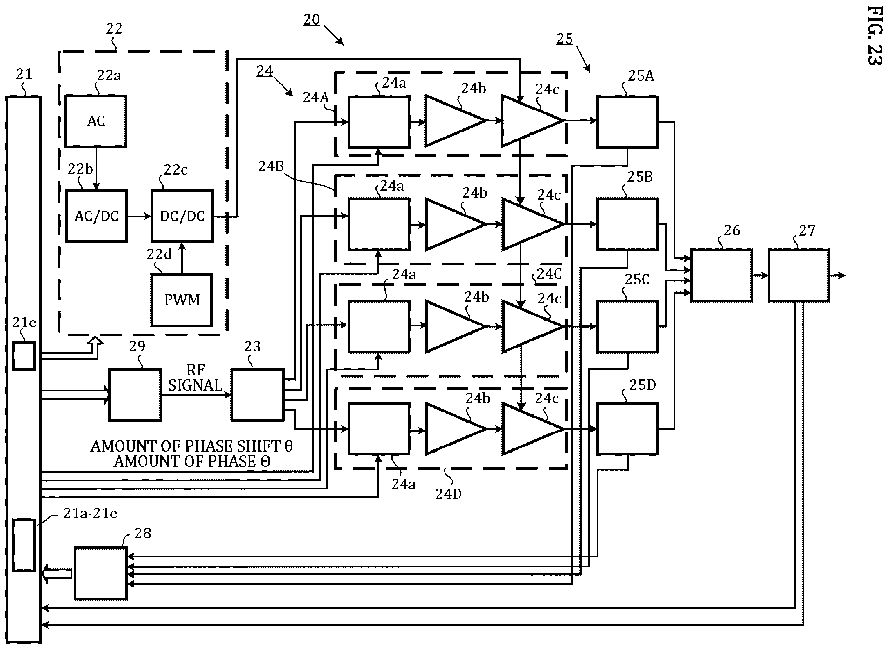

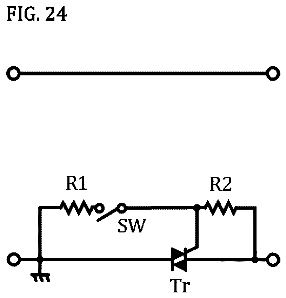

In a case where the power amplifier of the power amplification unit consists of switching amplifiers including a phase control unit, a manipulated variable MV is set based on an amount of phase shift θ and an amount of phase Θ. Now, a configuration example of a high-frequency power supply device employing the switching amplifiers will be described by referring to FIG. 23, and a configuration example of the phase control unit will be described by referring to FIG. 24.

### Configuration Example 1:

Figure 23 is a block diagram illustrating a configuration example of the high-frequency power supply device of the present invention that employs the switching amplifiers.

Configuration Example 1 illustrates that a manipulated variable MV for controlling the output level of the amplifier output of each power amplifier is controlled based on the amount of phase shift θ and the amount of phase Θ, and the output level of the high-frequency power supply device is controlled by increasing or decreasing a DC voltage in a DC power supply. Configuration Example 1 shows that the increase and decrease in the DC voltage in the DC power supply is carried out by PWM control.

A high-frequency power supply device 20 includes a control unit 21, a DC power supply unit 22, a distribution unit 23, a power amplification unit 24, an amplifier output detection unit 25, a power synthesis unit 26, a synthetic output detection unit 27, an A/D converter 28, and an RF signal generation unit 29.

The DC power supply unit 22 is configured to be capable of controlling a DC voltage, and includes an AC power supply 22a, an AC/DC conversion unit 22b that converts an AC voltage in the AC power supply 22a into a DC voltage, a DC/DC conversion unit 22c that conducts the PWM control to amplify the amplitude of the DC voltage converted by the AC/DC conversion unit 22b, and a PWM signal generation unit 22d that generates a PWM signal to be used for the PWM control by the DC/DC conversion unit 22c.

The DC/DC conversion unit 22c outputs the DC voltage according to a duty ratio of the PWM signal based on the PWM signal generated by the PWM signal generation unit 22d to thereby apply the DC voltage to a terminal stage power amplifier 24c.

The power amplification unit 24 includes multiple power amplifiers 24A, 24B ... 24N. Each of the power amplifiers 24A to 24N is configured by connecting in series each of digital amplifiers of an RF phase conversion unit/phase control unit 24a, a driver circuit 24b and a terminal stage power amplifier 24c. The RF signal generated by the RF signal generation unit 29 is distributed over the power amplifiers 24A, 24B ... 24N through the distribution unit 23. The RF phase conversion unit/phase control unit 24a converts the RF signal distributed from the distribution unit 23 into a phase shift signal, and then conducts the phase shift control on the output level of the amplifier output of each of the power amplifiers 24A, 24B ... 24N. The DC voltage applied from the DC power supply unit 22 is adjusted by the PWM control so as to adjust the voltage in the terminal stage power amplifier 24c, thereby increasing the accuracy of the power control.

The RF phase conversion unit/phase control unit 24a can adopt a DC/RF converter of a class-D amplifier consisting of a bridge circuit formed by semiconductor switching elements.

The RF phase conversion unit/phase control unit 24a of the power amplifier 24A and the RF phase conversion unit/phase control unit 24a of the power amplifier 24B are subjected to the phase shift control based on the amount of phase shift θ and the amount of phase Θ so as to synthetize the power by the power synthesis unit 26. Correspondingly, the RF phase conversion unit/phase control unit 24a of the power amplifier 24C and the RF phase conversion unit/phase control unit 24a of the power amplifier 24D are subjected to the phase shift control based on the amount of phase shift θ and the amount of phase Θ so as to synthetize the power by the power synthesis unit 26.

The control unit 21 includes a phase shift amount setting control unit 21a that controls the phase of switching in the RF phase conversion unit/phase control unit 24a of each power amplifier (24A to 24N) of the power amplification unit 24, a power amplifier abnormality detection unit 21b that detects an abnormality in the power amplifier (24A to 24N), a distribution control unit 21c that controls the distribution of the RF signal by the distribution unit 23, an RF signal setting unit 21d that sets the frequency and the signal level of the high-frequency signal (RF signal), and a DC power supply control unit 21e that controls the output level of the terminal stage power amplifier 24c.

The phase shift amount setting control unit 21a includes an amplifier output reference value setting unit 21a-1 and a manipulated variable setting unit 21a-2. In FIG. 23, the amplifier output reference value setting unit 21a-1 and the manipulated variable setting unit 21a-2 are omitted.

The amplifier output reference value setting unit 21a-1 sets an amplifier output reference value p_{ref} for defining the output level of the amplifier output of each power amplifier 24A to 24N. The manipulated variable setting unit 21a-2 compares the amplifier output feedback value p_{fb} detected by the amplifier output detection unit 25 with the amplifier output reference value p_{ref} set by the amplifier output reference value setting unit 21a-1, and based on this comparison, the amount of phase shift θ for controlling the output level of the amplifier output of each of the power amplifiers 24A to 24N is set for each power amplifier 24A to 24N. The RF phase conversion unit/phase control unit 24a of each power amplifier 22A to 24N is controlled based on the amount of phase shift θ so that the deviation between the amplifier output feedback value p_{fb} and the amplifier output reference value p_{ref} is reduced. The amount of phase shift θ is equivalent to an amplifier gain. The output level of the amplifier output of each power amplifier 24A to 24N of the power amplification unit 24 is controlled based on the amount of phase shift θ.

The amplifier output reference value setting unit 21a-1 sets the amplifier output reference value p_{ref} (amplifier output command value p_{com}, amplifier output conversion value p_{FB}) for providing an instruction about the output level of the amplifier output of each power amplifier 24A to 24N based on the synthetic output command value P_{com} for defining the level of an output from an output end OUT of the high-frequency power supply device 20 or the synthetic output feedback value P_{FB} detected by the synthetic output detection unit 27.

The amplifier output reference value setting unit 21a-1 sets the amplifier output reference value p_{ref} (amplifier output command value p_{com}, amplifier output conversion value p_{FB}) by proportionately dividing the synthetic output command value P_{com} or the synthetic output feedback value P_{FB} based on the number N of the power amplifiers 24A to 24N and the output power/power supply efficiency of each of the power amplifiers 24A to 24N. The output level of the terminal stage power amplifier 24c can be controlled by DC power supply voltage of the DC power supply control unit 21e.

### Configuration Example 2:

In Configuration Example 2, the RF phase conversion unit/phase control unit 24a is replaced with a phase controller using such as triacs.

Configuration Example 1 shows the case of the RF phase conversion unit/phase control unit 24a in which the RF phase conversion unit converts a signal into a phase shift signal, and the phase control unit conducts the phase shift control on each of the power amplification unit.

On the other hand, the phase controller of Configuration Example 2 is configured to conduct power control by controlling a timing of energizing a triac with an amount of phase Θ. The phase controller of Configuration Example 2 uses the amount of phase Θ to control ON/OFF of the switching element of the triac instead of using the RF phase conversion unit/phase control unit 24a in order to control the power of an amplifier output.

Figure 24 shows one configuration example of the phase controller using the triacs. The phase controller connects a series circuit consisting of resistors and a switching element to a triac in parallel, and connects the connection end between the switching element and one of the resistors to a gate end of the triac. The timing in turning the switching element on is adjusted by the amount of phase Θ to thereby control the power of the amplifier output.

### [INDUSTRIAL APPLICABILITY]

The high-frequency power supply device of the present invention can be applied to a high-frequency power supply (RF generator) which is used for a semiconductor manufacturing device, a liquid crystal panel manufacturing device and others.

### [REFERENCE SIGNS LIST]

1 Control Unit
1a Amplifier Control Unit
1a-2 Manipulated Variable Setting Unit
1a-1 Amplifier Output Reference Value Setting Unit
1b Amplifier Abnormality Detection Unit
1c Distribution Control Unit
1d RF Signal Setting Unit
2 RF Signal Unit
3 Distribution Unit
4 Power Amplification Unit
4A, 4B Power Amplifier
5 Amplifier Output Detection Unit
6 Power Synthesis Unit
7 Synthetic Output Detection Unit
10 High-Frequency Power Supply Device
11 Control Unit
11a Amplifier Control Unit
11a-1 Amplifier Output Reference Value Setting Unit
11a-2 Manipulated Variable Setting Unit
11b Power Amplifier Abnormality Detection Unit
11c Distribution Control Unit
11d RF Signal Setting Unit
12 RF Signal Unit
12a RF Signal Generation Unit
12b Power Control Amplifier
12c Power Control Interface
13 Distribution Unit
14 Power Amplification Unit
14A to 14D Power Amplifier
14a Variable Gain Amplifier
14b Driver Amplifier
14c Terminal Stage Power Amplifier
15 Amplifier Output Detection Unit
16 Power Synthesis Unit
17 Synthetic Output Detection Unit
18 A/D Converter
19 D/A Converter
20 High-Frequency Power Supply Device
21 Control Unit
21a Phase Shift Amount Setting Control Unit
21a-1 Amplifier Output Reference Value Setting Unit
21a-2 Manipulated Variable Setting Unit
21b Power Amplifier Abnormality Detection Unit
21c Distribution Control Unit
21d RF Signal Setting Unit
21e DC Power Supply Control Unit
22 DC Power Supply Unit
22A to 24N Power Amplifier
22a AC Power Supply
22d PWM Signal Generation Unit
23 Distribution Unit
24 Power Amplification Unit
24A to 24N Power Amplifier
24B, 24C, 24D Power Amplifier
24a RF Phase Conversion Unit/Phase Control Unit
24b Driver Circuit
24c Terminal Stage Power Amplifier
25 Amplifier Output Detection Unit
26 Power Synthesis Unit
27 Synthetic Output Detection Unit
28 A/D Converter
29 RF Signal Generation Unit
Aₜₜ Amount of Attenuation
Aₜₜₒ Initial Amount of Attenuation
EF, EF1 to EF4 Power Supply Efficiency
EFO Initial Power Supply Efficiency
MV Manipulated Variable
MVo Initial Value
OUT Output End
P_{FB}, P_{FB1}, P_{FB2} Synthetic Output Feedback Value
p_{fb}, p_{fb1}, p_{fb2} Amplifier Output Feedback Value
Pₗᵢₘᵢₜ Lower Limit Output
Pₒᵤₜ, Pₒᵤₜ₁, Pₒᵤₜ₂, Pₒᵤₜ₃ Synthetic Output
Pₜₕ₁, Pₜₕ₂ Synthetic Output Threshold Value
PS High-Frequency Power Supply Device
p_{FB} Amplifier Output Conversion Value
p_{com} Amplifier Output Command Value
pₒᵤₜ, pₒᵤₜ₁, pₒᵤₜ₂, pₒᵤₜ₃ Amplifier Output
p_{ref} Amplifier Output Reference Value
pₜₕ Threshold Value
pₜₕ₃, pₜₕ₄ Amplifier Output Threshold Value
Δ1, Δ2 Difference
ΔP Tolerance
ΔP_{FB} Difference
Δp_{fb} Difference
Θ Amount of Phase
θ Amount of Phase Shift

## Claims

1. A high-frequency power supply device, comprising:
a power amplification unit consisting of multiple amplifiers arranged to connect in parallel;
a distribution unit that distributes a high-frequency signal over the amplifiers of each power amplification unit;
a power synthesis unit that synthesizes power of a plurality of amplifier outputs which are amplified in each power amplification unit and outputs a synthetic output thus obtained;
an amplifier output detection unit that detects an amplifier output of the power amplification unit and outputs an amplifier output feedback value p_{fb};
a synthetic output detection unit that is connected between the power synthesis unit and an output end, and that separates forward power and detects a synthetic output feedback value P_{FB} of a synthetic output of the power synthesis unit; and
a control unit that defines an amplifier output command value p_{com} for defining an output level of each amplifier output, compares each amplifier output feedback value p_{fb} detected by the amplifier output detection unit with the amplifier output command value p_{com}, sets a manipulated variable MV for controlling the output level of each amplifier output of each power amplification unit for each power amplification unit, and controls the output level of each amplifier output of each power amplification unit based on the manipulated variable MV,
wherein the control unit defines the amplifier output command value p_{com} based on a synthetic output command value P_{com} for defining a target value of the synthetic output of the power synthesis unit or the synthetic output feedback value P_{FB}.

2. The high-frequency power supply device according to claim 1, wherein the control unit defines the amplifier output command value p_{com} of each power amplification unit based on the synthetic output command value P_{com} for defining an output level of the synthetic output, the number N of the power amplification unit (where N is an integer of 2 or more), and output power/power supply efficiency characteristics of each power amplification unit, and
sets the manipulated variable MV used for the control such that the amplifier output feedback value p_{fb} detected by the amplifier output detection unit is to be the amplifier output command value p_{com}.

3. The high-frequency power supply device according to claim 2, wherein each power amplification unit has the same output power/power supply efficiency characteristics, and
the control unit defines a uniform output of a value (synthetic output command value P_{com}/number N: (P_{com}/N)) obtained by dividing the synthetic output command value P_{com} by the number N of the power amplification unit as the amplifier output command value p_{com} of each power amplification unit.

4. The high-frequency power supply device according to claim 2, wherein each power amplification unit has unique output power/power supply efficiency characteristics, and
the control unit defines each output power value, which is defined for the same power supply efficiency for the output power/power supply efficiency characteristics unique to each power amplification unit, as the amplifier output command value p_{com} of each power amplification unit so that the sum of the amplifier output command values p_{com} is to be the synthetic output command value P_{com}.

5. The high-frequency power supply device according to claim 1, wherein the control unit defines the amplifier output command value p_{com} of each power amplification unit based on the synthetic output feedback value P_{FB} of the power synthesis unit, the number N of the power amplification unit, and the output power/power supply efficiency characteristics of each power amplification unit, and sets the manipulated variable MV used for the control such that the amplifier output feedback value p_{fb} detected by the amplifier output detection unit is to be the amplifier output command value p_{com}.

6. The high-frequency power supply device according to claim 5, wherein each power amplification unit has the same output power/power supply efficiency characteristics, and
the control unit defines a uniform output of a value (synthetic output feedback value P_{FB}/number N of the power amplification unit: (P_{FB}/N)) obtained by dividing the synthetic output feedback value P_{FB} by the number N of the power amplification unit as the amplifier output command value p_{com} of each power amplification unit.

7. The high-frequency power supply device according to claim 2, wherein each power amplification unit has unique output power/power supply efficiency characteristics, and
the control unit defines each output power value, which is defined for the same power supply efficiency for the output power/power supply efficiency characteristics unique to the power amplification unit, as the amplifier output command value p_{com} of each power amplification unit so that the sum of the amplifier output command values p_{com} is to be the synthetic output feedback value P_{FB}.

8. The high-frequency power supply device according to any one of claims 1 to 7, wherein each amplifier of each power amplification unit consists of a linear amplifier that includes an amplifier with a variable attenuator, and
the manipulated variable MV is an amount of attenuation of the variable attenuator of the amplifier with the variable attenuator.

9. The high-frequency power supply device according to any one of claims 1 to 7, wherein each amplifier of each power amplification unit consists of a switching amplifier that includes a phase control unit, and
the manipulated variable MV is an amount of phase of the phase control unit.

10. The high-frequency power supply device according to any one of claims 2 to 7, wherein the control unit detects an abnormality in the power amplification unit based on a comparison between the synthetic output feedback value P_{FB} and the synthetic output command value P_{com} or an amount of fluctuation of the synthetic output feedback value P_{FB}.

11. The high-frequency power supply device according to any one of claims 2 to 7, wherein the control unit detects an abnormality in the power amplification unit based on a comparison between the amplifier output feedback value p_{fb} and the amplifier output command value p_{com} or an amount of fluctuation of the amplifier output feedback value p_{fb}.

12. A method for controlling a high-frequency power supply device that comprises:
a power amplification unit consisting of multiple amplifiers arranged to connect in parallel;
a distribution unit that distributes a high-frequency signal over the amplifiers of each power amplification unit; and
a power synthesis unit that synthesizes power of a plurality of amplifier outputs which are amplified in each power amplification unit and outputs a synthetic output thus obtained, wherein
(a) an amplifier output command value p_{com} for defining an output level of each amplifier output is defined based on a synthetic output command value P_{com} for defining a target value of the synthetic output of the power synthesis unit or a synthetic output feedback value P_{FB} of the synthetic output of the power synthesis unit;
(b) an amplifier output feedback value p_{fb} is compared with the amplifier output command value p_{com} of each amplifier output;
(c) a manipulated variable MV for controlling the output level of each amplifier output is set foreach power amplification unit; and
(d) the output level of each amplifier output of each power amplification unit is controlled based on each manipulated variable MV.

13. The method for controlling the high-frequency power supply device according to claim 12, wherein the amplifier output command value p_{com} of each power amplification unit is defined based on the synthetic output command value P_{com}, a number N of the power amplification unit, and output power/power supply efficiency characteristics of each power amplification unit, and
the manipulated variable MV is set that controls the amplifier output feedback value p_{fb} to be the amplifier output command value p_{com}.

14. The method for controlling the high-frequency power supply device according to claim 12, wherein the amplifier output command value p_{com} of each power amplification unit is defined based on the synthetic output feedback value P_{FB}, the number N of the power amplification unit, and the output power/power supply efficiency characteristics of each power amplification unit, and
the manipulated variable MV is set that controls the amplifier output feedback value p_{fb} to be the amplifier output command value p_{com}.
